(19) Europäisches Patentamt
European Patent Office
Office européen des brevets

(11) **EP 4 764 614 A1**

(12) **EUROPEAN PATENT APPLICATION**

(43) Date of publication:
**24.06.2026 Bulletin 2026/26**

(21) Application number: **25215228.5**

(22) Date of filing: **12.11.2025**

(51) International Patent Classification (IPC):
*G01T 1/24* (2006.01)    *G01T 1/29* (2006.01)
*H01J 37/244* (2006.01)

(52) Cooperative Patent Classification (CPC):
**G01T 1/29; G01T 1/247; H01J 37/222;
H01J 37/244;** H01J 2237/2446; H01J 2237/24495;
H01J 2237/2802

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **18.12.2024 US 202418985639**

(71) Applicant: **FEI Electron Optics B.V.
5651GG Eindhoven (NL)**

(72) Inventors:
• **VESPUCCI, Stefano**
  **Eindhoven (NL)**
• **MELE, Luigi**
  **Eindhoven (NL)**
• **JANSSEN, Bart**
  **Lent (NL)**

(74) Representative: **Boult Wade Tennant LLP
Salisbury Square House
8 Salisbury Square
London EC4Y 8AP (GB)**

(54) **CHARGED-PARTICLE COUNTING VIA NON-BACKTHINNED INTEGRATION DETECTORS AND BEAM ENERGY QUANTIZATION**

(57)    Systems/techniques are provided for facilitating charged-particle counting via non-backthinned integration detectors and beam energy quantization. In various embodiments, a system can access an energy integration image of a specimen scanned by a charged-particle microscope equipped with a non-backthinned integration detector. In various aspects, the system can count how many charged-particle events are represented by respective pixels of the energy integration image, based on rounding cumulative charged-particle energy intensities indicated by respective clusters of pixels to nearest integer multiples of a beam energy of the charged-particle microscope.

```
┌─────────────────────────────────────┐
│ SCIENTIFIC INSTRUMENT MODULE         │
│              102                     │
│   ┌───────────────────────────┐     │
│   │  FIRST (IMAGE ACCESS)      │     │
│   │         LOGIC              │     │
│   │          104               │     │
│   └───────────────────────────┘     │
│   ┌───────────────────────────┐     │
│   │  SECOND (QUANTIZATION-     │     │
│   │  BASED COUNTING ) LOGIC    │     │
│   │          106               │     │
│   └───────────────────────────┘     │
└─────────────────────────────────────┘
```

**FIG. 1**

EP 4 764 614 A1

**Description**

BACKGROUND

Accurately counting how many charged-particles strike an integration detector of a charged-particle microscope can be difficult.

SUMMARY

The following presents a summary to provide a basic understanding of one or more embodiments. This summary is not intended to identify key or critical elements, or delineate any scope of the particular embodiments or any scope of the claims. Its sole purpose is to present concepts in a simplified form as a prelude to the more detailed description that is presented later. In one or more embodiments described herein, devices, systems, computer-implemented methods, apparatus or computer program products that facilitate charged-particle counting via non-backthinned integration detectors and beam energy quantization are described.

According to one or more embodiments, a system is provided. The system can comprise a non-transitory computer-readable memory that can store computer-executable components. The system can further comprise a processor that can be operably coupled to the non-transitory computer-readable memory and that can execute the computer-executable components stored in the non-transitory computer-readable memory. In various embodiments, the computer-executable components can comprise a scan component that can access an energy integration image of a specimen scanned by a charged-particle microscope equipped with a non-backthinned integration detector. In various aspects, the computer-executable components can comprise a quantization component that can count how many charged-particle events are represented by respective pixels of the energy integration image, based on rounding cumulative charged-particle energy intensities indicated by respective clusters of pixels to nearest integer multiples of a beam energy of the charged-particle microscope.

According to one or more embodiments, a computer-implemented method is provided. In various embodiments, the computer-implemented method can comprise accessing, by a device operatively coupled to a processor, an energy integration image of a specimen scanned by a charged-particle microscope equipped with a non-backthinned integration detector; and counting, by the device, how many charged-particle events are represented by respective pixels of the energy integration image, based on rounding cumulative charged-particle energy intensities indicated by respective clusters of pixels to nearest integer multiples of a beam energy of the charged-particle microscope.

According to one or more embodiments, a computer program product for facilitating charged-particle counting via non-backthinned integration detectors and beam energy quantization is provided. In various embodiments, the computer program product can comprise a non-transitory computer-readable memory having program instructions embodied therewith. In various aspects, the program instructions can be executable by a processor to cause the processor to access an energy integration image of a specimen scanned by an electron energy-loss microscope equipped with a non-backthinned integration detector. In various instances, the program instructions can be executable by the processor to cause the processor to count how many electron events are represented by respective pixels of the energy integration image, based on rounding cumulative electron energy intensities indicated by respective clusters of pixels to nearest integer multiples of a beam energy of the electron energy-loss microscope.

DESCRIPTION OF THE DRAWINGS

Various embodiments will be readily understood by the following detailed description in conjunction with the accompanying figures. To facilitate this description, like reference numerals designate like structural elements. Embodiments are illustrated by way of example, not by way of limitation, in the figures. The figures are not necessarily drawn to scale.

FIG. 1 illustrates an example, non-limiting block diagram of a scientific instrument module in accordance with various embodiments described herein.
FIG. 2 illustrates an example, non-limiting flow diagram of a computer-implemented method in accordance with various embodiments described herein.
FIG. 3 illustrates a block diagram of an example, non-limiting system that facilitates charged-particle counting via non-backthinned integration detectors and beam energy quantization in accordance with one or more embodiments described herein.
FIG. 4 illustrates a block diagram of an example, non-limiting system including an energy integration image and a beam energy that facilitates charged-particle counting via non-backthinned integration detectors and beam energy quantization in accordance with one or more embodiments described herein.
FIGs. 5-7 illustrate example, non-limiting block diagrams showing how an energy integration image can be accessed in accordance with one or more embodiments described herein.
FIG. 8 illustrates a block diagram of an example, non-limiting system including pixel-wise charged-particle counts that facilitates charged-particle counting via non-backthinned integration detectors and beam energy quantization in accordance with one or more embodiments described herein.
FIGs. 9-12 illustrate example, non-limiting block diagrams showing how pixel-wise charged-particle counts can be determined in accordance with one or more embodiments described herein.

FIGs. 13-14 illustrate experimental results associated with an example, non-limiting implementation of one or more embodiments described herein.

FIG. 15 illustrates a block diagram of an example, non-limiting operating environment in which one or more embodiments described herein can be facilitated.

FIG. 16 illustrates an example networking environment operable to execute various implementations described herein.

FIG. 17 illustrates an example dual beam microscope that can be implemented in accordance with various embodiments described herein.

DETAILED DESCRIPTION

The following detailed description is merely illustrative and is not intended to limit embodiments or application/uses of embodiments. Furthermore, there is no intention to be bound by any expressed or implied information presented in the preceding Background or Summary sections, or in the Detailed Description section.

One or more embodiments are now described with reference to the drawings, wherein like referenced numerals are used to refer to like elements throughout. In the following description, for purposes of explanation, numerous specific details are set forth in order to provide a more thorough understanding of the one or more embodiments. It is evident, however, in various cases, that the one or more embodiments can be practiced without these specific details.

Various operations can be described as multiple discrete actions or operations in turn, in a manner that is most helpful in understanding the subject matter disclosed herein. However, the order of description should not be construed as to imply that these operations are necessarily order dependent. In particular, these operations can be performed in an order different from the order of presentation. Operations described can be performed in a different order from the described embodiments. Various additional operations can be performed, or described operations can be omitted in additional embodiments.

Although some elements may be referred to in the singular (e.g., "a processing device"), any appropriate elements may be represented by multiple instances of that element, and vice versa. For example, a set of operations described as performed by a processing device may be implemented with different ones of the operations performed by different processing devices. As used herein, the phrase "based on" should be understood to mean "based at least in part on," unless otherwise specified.

A charged-particle microscope (e.g., a scanning electron microscope (SEM), a transmission electron microscope (TEM), a dual beam microscope, an electron energy-loss microscope (EELM), an energy-dispersive X-ray microscope (EDM)) can be any suitable computerized device that can capture or generate microscopic or nanoscopic images of specimens in a scientific, laboratory, research, or clinical operational environment. To facilitate the capture or generation of such images, charged-particle microscopes can leverage complex arrangements of actuatable parts (e.g., ion sources, electron sources, optical lenses or apertures, optical plates or deflectors, columns, coils, heaters, coolers, fluid valves, fluid pumps, circuit switches, specimen stages), sensors (e.g., ion detectors, electron detectors, voltmeters, thermistors, potentiometers, pressure gauges), or consumables (e.g., carrier fluids, calibrants, filters, reactive gases).

In various situations, a charged-particle microscope (e.g., an EELM in particular) can reveal material properties or compositional characteristics of a specimen (e.g., an integrated circuit chip, a semiconductor wafer, a lamella, a biological or organic sample) by irradiating the specimen with a beam of charged-particles (e.g., electrons, X-ray photons) and by counting how many charged-particles belonging to respective energy energy-loss levels pass through the specimen (e.g., the particles can transfer, and thus lose, respective amounts of their energies to the specimen). In some aspects, the charged-particle microscope can have or possess an energy dispersive filter that can: permit only charged-particles having a desired or selected energy-loss to reach a detector of the charged-particle microscope; or direct or aim charged-particles having different energy-losses at respective cells of the detector (e.g., such that each cell is struck only by particles having a single, respective energy-loss). In any case, counting how many charged-particles having respective energy-losses strike the detector of the charged-particle microscope can reveal valuable compositional information regarding the specimen through which those charged-particles passed.

Some charged-particle microscopes are equipped or outfitted with pulse-counting detectors (e.g., Geiger-Muller counters, scintillation detectors, Channeltron® detectors). The hardware of a pulse-counting detector is specifically designed or configured to detect or count how many individual charged-particles strike it.

In contrast, many other charged-particle microscopes are equipped or outfitted with integration detectors (e.g., charge-coupled devices, Faraday cup detectors). Unlike the hardware of a pulse-counting detector, the hardware of an integration detector is instead specifically designed or configured to accumulate, sum, or integrate over time the energies of charged-particles that strike it. So, when operating in a normal, standard, or default integration mode, an integration detector does not output or produce charged-particle counts. Instead, it outputs or produces accumulated, summed, or integrated energy signals.

In order to allow a charged-particle microscope that has an integration detector to count charged-particles, existing techniques have developed a counting mode for integration detectors. When implemented in counting mode, an integration detector does not accumulate, sum, or measure the energies of incoming charged-particles. Rather, when implemented in counting mode, an integration detector operates in a binary struck-or-not-struck fashion. In particular, any given cell of the integration detector can be considered as having a sampling rate and a sampling iteration. The sampling rate of the given cell can be considered as defining how quickly or how fast the given cell can record or register signals, whereas the sampling iteration of the given cell can instead be considered as the length of time (e.g., usually measured in microseconds or milliseconds) that is consumed by the given cell in recording or registering a single signal. Thus, the sampling iteration can be considered as being inversely proportional to the sampling rate of the given cell (e.g., a higher sampling rate can correspond to a shorter sampling iteration; conversely, a lower sampling rate can correspond to a longer sampling iteration). In any case, the given cell can, for each sampling iteration that occurs or transpires while operating in counting mode, indicate either that: the given cell was struck by a charged-particle; or the given cell was not struck by a charged-particle. So, there can be a running count that corresponds to the given cell and whose initial value is zero, that running count can be incremented during each sampling iteration that the given cell indicates that it was struck, and the running count can instead be not incremented during each sampling iteration that the given cell indicates that it was not struck. After any suitable desired number of sampling iterations elapses, the final value of the running count is treated by existing techniques as indicating how many charged-particles struck the given cell. In many cases, counting sensitivity of the given cell can be increased if the integration detector is backthinned. In other words, counting sensitivity of the given cell can be increased if a thickness of the integration detector is thinner or lesser than a penetrating depth of the charged-particles that strike it.

Unfortunately, existing techniques for counting charged-particles via integration detectors are vulnerable to the pile-up effect. The pile-up effect refers to the following: when two or more distinct charged-particles strike the same cell as each other simultaneously, in quick succession, or otherwise within the same sampling iteration as each other (e.g., at a speed that is greater than the integration detector's temporal resolution), that cell can fail to independently or separately register or record those two or more distinct charged-particles. Instead, that cell can mistakenly register or record a single charged-particle.

As a non-limiting example, consider a given integration detector cell that is operating in counting mode and that is struck by a particle A and a particle B. Suppose that the particle A strikes the given integration detector cell during a sampling iteration X and that the particle B strikes the given integration detector cell during a sampling iteration Y, where the sampling Y is after or later than the sampling iteration X. In such case, during the sampling iteration X, the given integration detector cell can produce or output a "struck" signal and can accordingly increment its running count by one. Additionally, during the sampling iteration Y, the given integration detector cell can produce or output another "struck" signal and can accordingly increment its running count by one again. Note how the running count in such situation is incremented twice: once for the particle A and once for the particle B. Thus, because the particle A and the particle B occurred during different sampling iterations, the given integration detector cell is able to correctly count them. Now, suppose instead that the particle A and the particle B both strike the given integration detector cell during a sampling iteration Z. In such case, during the sampling iteration Z, the given integration detector cell can produce or output a "struck" signal and can accordingly increment its running count by one. Note how the running count in this situation is incremented only once. In other words, because the particle A and the particle B occurred during the same sampling iteration as each other, the given integration detector cell is unable to correctly count them. In other words, the particle A and the particle B can be considered as piling-up on the given integration detector cell, such that the given integration detector cell cannot accurately tell them apart and thus cannot accurately count them. Note that the pile-up problem can occur even if the given integration detector cell is backthinned (e.g., even if it has higher sensitivity due to having a thickness that is lesser than a penetration depth of the particles A and B).

In this way, existing techniques for counting charged-particles via integration detectors are prone to miscounting due to the pile-up effect.

Accordingly, systems or techniques that can ameliorate the pile-up effect can be desirable.

Various embodiments described herein can address this technical problem. One or more embodiments described herein can include systems, computer-implemented methods, apparatus, or computer program products that can facilitate charged-particle counting via non-backthinned integration detectors and beam energy quantization. In particular, the inventors of various embodiments described herein recognized that existing techniques for counting charged-particles via integration detectors operate in a binary struck-or-not fashion using backthinned cells. The present inventors noted that, because charged-particles fully or completely pass or penetrate through backthinned cells, those charged-particles deposit into those backthinned cells amounts of energy that usually range from a few electron-volts to a few kilo-electron-volts. The present inventors further noted that such deposited energies constitute, at most, a mere few percent of the beam energy that is initially imparted to those charged-particles by a charged-particle microscope. Moreover, the present inventors realized that, when a non-backthinned integration detector is implemented (e.g., an integration detector whose thickness is greater than or equal to the penetration depth of charged-particles that strike it), each charged-particle can be considered as depositing almost all (e.g., about 98% or more) of its initial energy into the non-backthinned integration detector of the charged-particle microscope. Accordingly, the present inventors devised various embodiments described herein, in which charged-particles can be counted by quantizing the total amount of energy that is deposited into each cell of the non-backthinned integration detector. In other words, rather than counting charged-particles in a binary struck-or-not fashion using a backthinned integration detector, various embodiments described herein can track or record the total amount of charged-particle energy that is deposited into each cell of a non-backthinned integration detector. By dividing such total amounts of charged-particle energies by the beam energy of the charged-particle microscope and subsequently rounding those quotients, the total number of charged-particles that strike each cell of the non-backthinned integration detector can be accurately or reliably estimated, even in the presence of charged-particle pile-ups. In other words, various embodiments described herein can be considered as an elegant pixel processing technique that is not adversely impacted or thrown off by the pile-up effect.

Various embodiments described herein can be considered as a computerized tool (e.g., any suitable combination of computer-executable hardware or computer-executable software) that can facilitate charged-particle counting via non-backthinned integration detectors and beam energy quantization. In various aspects, such computerized tool can comprise a scan component or a quantization component.

In various embodiments, there can be a charged-particle microscope. In various aspects, the charged-particle microscope can exhibit any suitable design or construction (e.g., can be an SEM, can be a TEM, can be a dual-beam microscope, can be an EELM). In various instances, there can be any suitable specimen (e.g., semiconductor wafer or lamella) that is loaded in the charged-particle microscope (e.g., that is currently located or positioned on an actuatable stage of the charged-particle microscope). In various cases, the charged-particle microscope can comprise an integration detector that is not or has not been backthinned. In other words, a thickness of the integration detector can be greater than whatever penetration depths are associated with charged-particles emitted by the charged-particle microscope.

In various aspects, it can be desired to perform electron counting on or with respect to the specimen. As described herein, the computerized tool can facilitate such electron counting.

In various embodiments, the computerized tool can electronically access the charged-particle microscope. For instance, the computerized tool can send electronic commands to, or can receive electronic data from, the charged-particle microscope. Accordingly, any components of the computerized tool can electronically interact with (e.g., activate, deactivate, read, write, edit, copy, manipulate) the charged-particle microscope in any suitable fashion.

In various embodiments, the scan component of the computerized tool can electronically cause the charged-particle microscope to scan the specimen using the integration detector, and such scanning can yield an energy integration image. In various aspects, the charged-particle microscope can perform such scanning via any suitable beam energy (e.g., any suitable beam voltage or beam current).

More specifically, the scan component can electronically instruct or command the charged-particle microscope to scan the specimen a plurality of times using the beam energy. Such scanning can yield a plurality of preliminary energy integration images of the specimen (e.g., one preliminary energy integration image per scan). In various instances, each preliminary energy integration image can be a two-dimensional pixel array, and each pixel of each preliminary energy integration image can indicate the total amount of energy that has been deposited into a respective integration detector cell of the charged-particle microscope during a respective scan. Note that each integration detector cell can be considered as recording, registering, or tracking detector-deposited energy (e.g., energy deposited into the detector) instead of specimen-deposited energy (e.g., energy lost to the specimen).

In various aspects, the scan component can convert the plurality of preliminary energy integration images into a plurality of floored energy integration images, by leveraging any suitable noise threshold. In various instances, the noise threshold can be any suitable scalar whose value or magnitude represents a maximum energy level that is known or deemed to serve as an upper bound on noise that might potentially affect any given integration detector cell. Indeed, even when a given integration detector cell is not struck by any charged-particles, the given integration detector cell can nevertheless register or record a non-zero amount of deposited energy due to random noise. If a registered or recorded energy level of the given integration detector cell is above the noise threshold, that registered or recorded energy level can be considered as not being just the result of noise (e.g., can instead be considered as the result of at least one charged-particle striking the given integration detector cell). In contrast, if a registered or recorded energy level of the given integration detector cell is below the noise threshold, that registered or recorded energy level can be considered as just the result of noise (e.g., can be considered as the result of no charged-particles striking the given integration detector cell). In various aspects, if the integrated energy value of any given pixel in the plurality of preliminary energy integration images is below the noise threshold, the scan component can replace the integrated energy value of that given pixel with a value of 0. That is, the scan component can floor the integrated energy value of that given pixel to 0. In contrast, if the integrated energy value of any given pixel in the plurality of preliminary energy integration images is above the noise threshold, the scan component can leave the integrated energy value of that given pixel unchanged. After this conditional flooring operation has been performed on each pixel, the plurality of preliminary energy integration images can be referred to as the plurality of floored energy integration images.

In various aspects, the scan component can electronically generate the energy integration image, by combining or aggregating the plurality of floored energy integration images together. For example, the energy integration image can be equal to a pixel-wise sum or pixel-wise average of the plurality of floored energy integration images. By generating the energy integration image in this fashion (e.g., via flooring and aggregating), situations in which noise drowns out or overwhelms low-dose charged-particle counts can be avoided or prevented.

In various embodiments, the quantization component of the computerized tool can electronically compute or calculate pixel-wise charged-particle counts for the energy integration image, by leveraging the beam energy that the charged-particle microscope used to generate the energy integration image.

More specifically, the quantization component can electronically apply any suitable community detection algorithm (e.g., Louvain algorithm, Girvan-Newman algorithm) to the energy integration image. In various aspects, this can cause the quantization component to identify a plurality of pixel clusters within the energy integration image. In various instances, each pixel cluster can be a spatially contiguous or cohesive set of pixels that have non-zero integrated energy values. For any given pixel cluster, the quantization component can, in various instances, sum or add the integrated energy values of the pixels in the given pixel cluster together, thereby yielding a cumulative integrated energy value. In various cases, the quantization component can divide the cumulative energy value by the beam energy that was implemented by the charged-particle microscope, thereby yielding a quotient. In various aspects, the quantization component can round the quotient to a nearest integer value. In various instances, that nearest integer value can be considered as being the total number of charged-particles that struck whatever integration detector cells correspond to (e.g., store their integrated energy values in) the given pixel cluster. Clustering in this way can be considered as beneficial at least because charged-particles can sometimes straddle multiple integration detector cells at once, thereby depositing their energies into more than one integration detector cell. In other words, some integration detector cells can sometimes absorb fractions of the initial energy of any given charged-particle. Clustering as described herein can help to ensure that such fractions are not ignored or miscounted.

Furthermore, the quantization component can, in some cases, determine how many charged-particles struck each individual pixel of the given pixel cluster. In particular, for any given pixel in the given pixel cluster, the quantization component can divide the integrated energy value of that given pixel by the cumulative integrated energy value of the given pixel cluster, thereby yielding a ratio. In various aspects, the quantization component can multiply that ratio by the total number of charged-particles that struck the integration detectors corresponding to the given pixel cluster. The resulting product of such multiplication can be a scalar indicating how many individual charged-particles (or fractions thereof) struck the given pixel.

For example, suppose that the charged-particle microscope used a beam energy of 100 keV. Additionally, suppose that the cumulative integrated energy value of the given pixel cluster is 873 keV (or is instead some unitless value that corresponds or is mapped to 873 keV). Moreover, suppose that the given pixel has an integrated energy value of 225 keV (or instead some unitless value that corresponds or is mapped to 225 keV). In such case, the quantization component can divide 873 keV by 100 keV, thereby yielding a quotient of 8.73. The quantization component can then round 8.73 to the nearest integer: 9. Thus, the quantization component can infer or conclude that 9 charged-particles struck the integration detector cells that correspond to the given pixel cluster. Next, the quantization component can divide 225 keV by 873 keV, thereby yielding a ratio: $\frac{225}{873}$. In various instances, the quantization component can multiply that ratio by 9, thereby yielding a scalar having a value of about 2.32. So, the quantization component can infer or conclude that 2.32 charged-particles struck whatever integration detector cell corresponds to the given pixel.

In this way, the quantization component can compute or calculate a respective charged-particle count for each pixel in the plurality of pixel clusters. In other words, the quantization component can compute or calculate a respective charged-particle count for each non-zero pixel in the energy integration image.

Note that such counts can be considered as being unimpeded or undegraded by the pile-up effect. That is, by quantizing (e.g., dividing) the cumulative energy values of respective pixel clusters with the beam energy of the charged-particle microscope, charged-particles can be accurately or reliably counted without regard to when they struck the detector, provided that the detector is not backthinned. Indeed, consider two or more particles that strike a non-backthinned integration detector cell. That non-backthinned integration detector cell can register or record all of the energy that is deposited into it by those two or more particles. That total amount of registered or recorded energy can be almost or about equal to the sum of the initial energies of those two or more particles. Thus, that total amount of registered or recorded energy does not depend upon whether those two or more particles strike the non-backthinned integration detector cell during the same sampling iteration as each other or instead during different sampling iterations as each other. Accordingly, beam energy quantization as described herein can be considered as a way of counting charged-particles without succumbing to the problem of pile-up.

In various embodiments, the computerized tool can perform any suitable electronic actions with respect to the pixel-wise charged-particle counts computed by the quantization component. As some examples, the computerized tool can render any of the pixel-wise charged-particle counts on any suitable electronic display, can transmit any of the pixel-wise charged-particle counts to any suitable computing device, or can otherwise utilize any of the pixel-wise charged-particle counts for any suitable downstream analysis (e.g., compositional analysis regarding the specimen).

Various embodiments described herein can be employed to use hardware or software to solve problems that are highly technical in nature (e.g., to facilitate charged-particle counting via non-backthinned integration detectors and beam energy quantization), that are not abstract and that cannot be performed as a set of mental acts by a human. Further, some of the processes performed can be performed by a specialized computer (e.g., electron microscopes such as EELMs) for carrying out defined acts related to the field of charged-particle microscopy.

For example, such defined acts can include: accessing, by a device operatively coupled to a processor, an energy integration image of a specimen scanned by a charged-particle microscope that is equipped with a non-backthinned energy integration detector; and counting, by the device, how many charged-particle events are represented by respective pixels of the energy integration image, based on rounding cumulative charged-particle energy intensities indicated by respective clusters of pixels to nearest integer multiples of a beam energy of the charged-particle microscope. In various aspects, such defined acts can further include: causing, by the device, the charged-particle microscope to capture a plurality of preliminary energy integration images of the specimen; assigning, by the device, zeros to pixels in the plurality of preliminary energy integration images whose charged-particle energy intensities fall below a noise threshold, thereby yielding a plurality of floored energy integration images; performing, by the device, pixel-wise summing or averaging of the plurality of floored energy integration images, thereby yielding the energy integration image; and identifying, by the device, the respective clusters by applying a community detection algorithm to the energy integration image. In various instances, for a first cluster having a first cumulative charged-particle energy intensity, such defined acts can include: dividing, by the device, the first cumulative charged-particle energy intensity by the beam energy of the charged-particle microscope, thereby yielding a quotient; rounding, by the device, the quotient to a nearest integer value, thereby yielding a rounded quotient; and determining, by the device, that a number of charged-particle events represented by the first cluster is equal to the rounded quotient. In various cases, for a first pixel in the first cluster and having a first integrated charged-particle energy intensity, such defined acts can further include: dividing, by the device, the first integrated charged-particle energy intensity by the first cumulative charged-particle energy intensity, thereby yielding a ratio; multiplying, by the device, the ratio by the rounded quotient, thereby yielding a product; and determining, by the device, that a number of charged-particle events represented by the first pixel is equal to the product.

Such defined acts are inherently computerized. Indeed, a charged-particle microscope (e.g., EELM) is a highly-technical computerized device comprising specific computerized hardware (e.g., temperature sensors, pressure sensors, voltage sensors, ion beam emitters, electron beam emitters, focusing lenses, ion detectors, electron detectors, beam apertures, fluid valves, actuatable specimen stages). A charged-particle microscope and the images that it captures cannot be implemented by the human mind, or by a human with pen and paper, in any reasonable or practicable way without computers. Furthermore, charged-particle counting (e.g., electron counting) is an inherently hardware-based task that cannot be performed in any reasonable or practical way by the human mind or by humans with mere pen and paper. Indeed, sub-atomic particles cannot be seen by the naked eye, and so they cannot be detected or counted without specialized hardware (e.g., integration detectors) that is specifically designed and constructed to physically respond to the presence or absence of such sub-atomic particles. It would make no sense whatsoever to discuss charged-particle counting outside of a computerized context.

Moreover, various embodiments described herein can integrate into a practical application various teachings relating to the field of charged-particle microscopy. As explained above, existing techniques for counting charged-particles via integration detectors are vulnerable to the pile-up effect. Specifically, when two or more charged-particles strike a given integration detector cell at the same time, in quick succession, or otherwise within the same sampling iteration as each other, the given cell can be unable to distinguish or disambiguate between the two or more charged-particles. Indeed, the given cell can be considered as operating in a binary or dichotomous struck-or-not-struck fashion. So, during whatever sampling iteration that the given cell is struck by the two or more charged-particles, whatever running count that is recorded by the given cell can be incremented only by one, notwithstanding that the given cell was actually struck by two or more charged-particles. That is, the two or more charged-particles can be considered as piling-up on the given cell, such that the given cell cannot accurately tell those two or more charged-particles apart. The pile-up effect thus causes existing techniques to inaccurately or incorrectly count how many charged-particles struck the given cell, which can be undesirable.

Various embodiments described herein can help to ameliorate one or more of these technical problems, by implementing charged-particle counting via non-backthinned integration detectors and beam energy quantization. In particular, the present inventors recognized that the reason that existing techniques suffer from the pile-up effect is because they force integration detectors to operate in a dichotomous, struck-or-not-struck, non-integration mode. The present inventors realized that by instead counting charged-particles based on the residual amounts of energy that charged-particles maintain after their interactions with the specimen, the pile-up effect can be negated. Specifically, each charged-particle that is emitted by a charged-particle microscope can be considered as having an initial amount of energy that is equal to the beam energy that the charged-particle microscope used to emit, produce, or propel the charged-particle. Additionally, each charged-particle that passes through the specimen and subsequently strikes a detector cell of the charged-particle microscope can be considered as losing only a very small proportion (e.g., maybe 2% on the high-end) of its initial energy in the specimen. Accordingly, almost all (e.g., about 98% or more) of the initial energy of the charged-particle can be considered as being deposited into the detector cell, as long as the detector cell is not backthinned. Because of this, when multiple charged-particles strike the same detector cell as each other, the total amount of energy deposited into that detector cell across all of such strikes can be almost equal to an integer multiple of the beam energy of the charged-particle microscope, where that integer multiple represents the number or cardinality of those multiple charged-particles. Note that, the detector cell can, by virtue of belonging to a non-backthinned integration detector, record, register, sum, or integrate the total amount of energy that is deposited into it. Also, note that the beam energy of the charged-particle microscope can be considered as a known, selectively controllable, or otherwise easily identifiable value. Accordingly, the total quantity of charged-particles that strike the detector cell can thus be estimated by dividing the total integrated amount of energy deposited into the detector cell by the beam energy, regardless of whether any of those multiple charged-particles struck the detector cell simultaneously, in quick succession, or otherwise in the same sampling iteration as each other. In other words, various embodiments described herein can be considered as a specific pixel processing technique that can be implemented on charged-particle microscopes that have non-backthinned integration detectors and that allows charged-particles to be accurately counted notwithstanding the pile-up effect. In still other words, various embodiments described herein can achieve higher or better charged-particle counting accuracy than existing techniques for counting via integration detectors are capable of achieving.

Additionally, the counter-intuitive character of various embodiments described herein must be emphasized. As explained above, the central or fundamental principles of existing techniques for counting charged-particles via integration detectors are the following: to operate in a binary struck-or-not-struck counting mode rather than in an integration mode; and to increase counting sensitivity via backthinning. The present inventors realized that these central or fundamental principles of existing techniques actually exacerbate the pile-up effect. Indeed, as described herein, the present inventors realized that pile-up effects can be negated by instead deriving charged-particle counts from residual energy (e.g., the amount of energy that charged-particles have remaining after interacting with a specimen) deposited into non-backthinned integration cells. After all, because each charged-particle can lose only a very small percentage of its initial energy in a specimen, each charged-particle can be considered as depositing almost all of its initial energy into a detector that has not been backthinned (in contrast, each charged-particle particle would instead lose only another small amount of its initial energy in a backthinned cell). So, dividing the total amount of energy encountered by any given non-backthinned integration detector cell by the beam energy with which charged-particles were propelled toward a specimen can yield a scalar that is almost equal to (e.g., that is within rounding distance of) the total number of charged-particles that struck the given non-backthinned integration detector cell. Counting charged-particles in this fashion can be considered as a paradigm shift in the field of charged-particle microscopy. Indeed, because the entire charged-particle microscopy industry conventionally teaches counting charged-particles via integration detectors that are backthinned and not operating in an integration mode, it is completely counterintuitive to instead count charged-particles via integration detectors that are not backthinned and that are operating in an integration mode. Stated differently, leveraging the fact that the total amount of energy encountered by any given non-backthinned integration detector cell can be approximately equal to a quantized or integer multiple of beam energy can be considered as a clever, innovative, or unusual way of counting charged-particles.

For at least the above reasons, various embodiments described herein can be considered as addressing or ameliorating various problems or disadvantages (e.g., the pile-up effect) that afflict existing techniques for facilitating charged-particle counting. Therefore, various embodiments described herein can be considered as a concrete and tangible technical improvement in the field of charged-particle microscopy. Accordingly, various embodiments described herein certainly qualify as useful and practical applications of computers.

Furthermore, various embodiments described herein can control real-world tangible devices based on the disclosed teachings. For example, various embodiments described herein can electronically activate, deactivate, or otherwise actuate real-world hardware (e.g., ion beam emitters, ion focusing lenses, carrier fluid valves/pumps) of real-world charged-particle microscopes (e.g., SEMs, TEMs, dual-beam microscopes, EELMs).

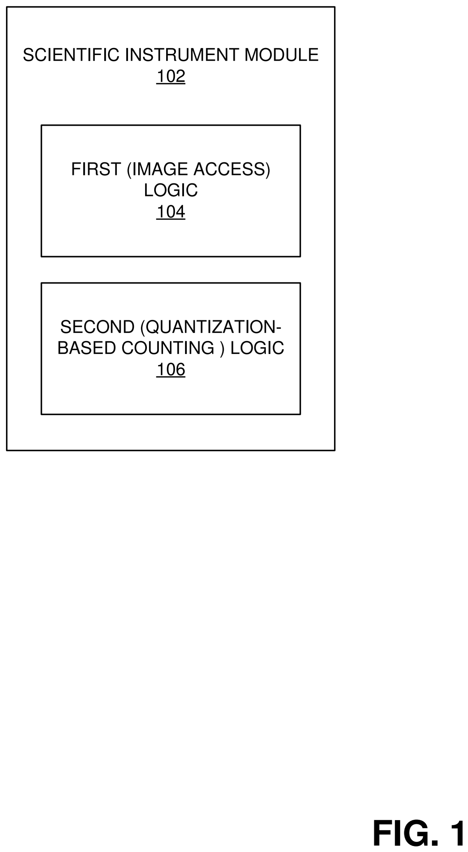

FIG. 1 illustrates an example, non-limiting block diagram of a scientific instrument module 102 in accordance with various embodiments described herein.

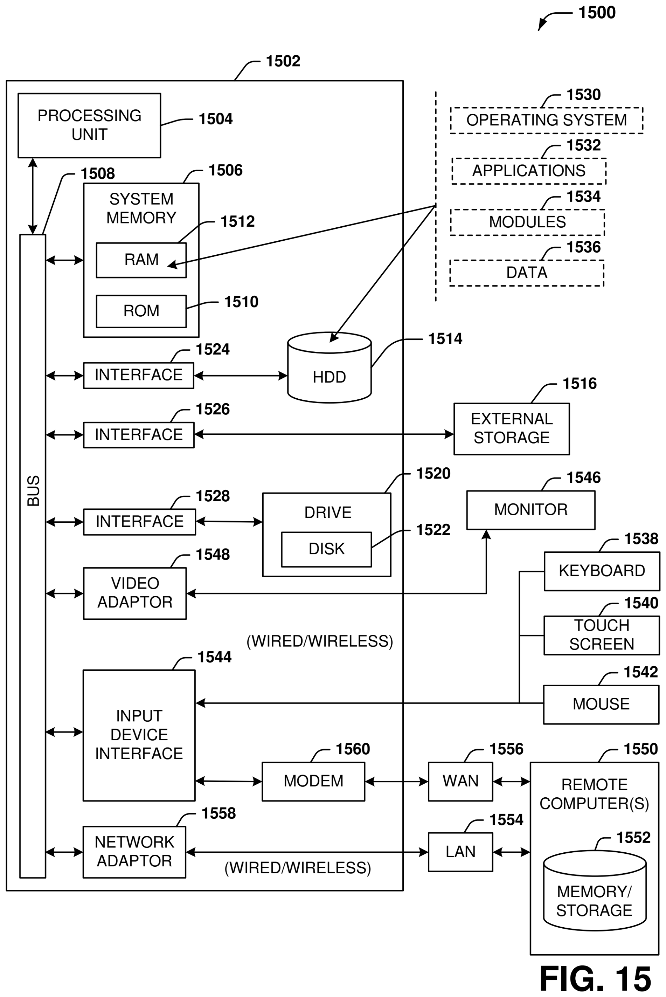

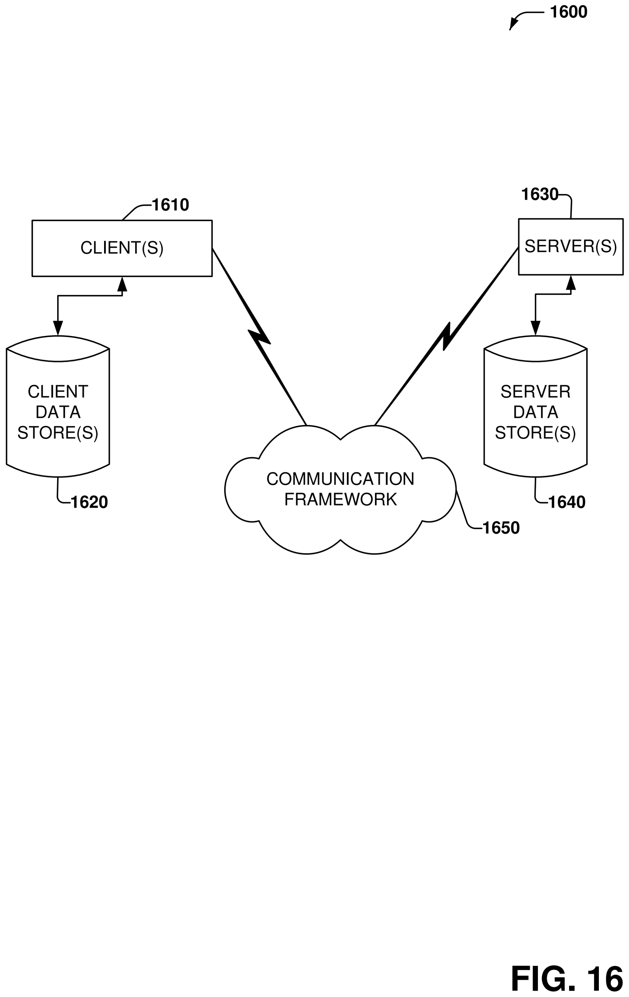

In various embodiments, the scientific instrument module 102 can be implemented by circuitry (e.g., including electrical or optical components), such as a programmed computing device. Logic of the scientific instrument module 102 can be included in a single computing device or can be distributed across multiple computing devices that are in communication with each other as appropriate. Examples of computing devices that may, singly or in combination, implement the scientific instrument module 102 are discussed herein with reference to FIG. 15, and examples of systems or networks of interconnected computing devices, in which the scientific instrument module 102 may be implemented across one or more of the computing devices, are discussed herein with reference to FIG. 16.

The scientific instrument module 102 can include first logic 104 and second logic 106. As used herein, the term "logic" can include an apparatus that is to perform a set of operations associated with the logic. For example, any of the logic elements included in the scientific instrument module 102 can be implemented by one or more computing devices programmed with instructions to cause one or more processing devices of the computing devices to perform the associated set of operations. In a particular embodiment, a logic element may include one or more non-transitory computer-readable media having instructions thereon that, when executed by one or more processing devices of one or more computing devices, cause the one or more computing devices to perform the associated set of operations. As used herein, the term "module" can refer to a collection of one or more logic elements that, together, perform a function associated with the module. Different ones of the logic elements in a module may take the same form or may take different forms. For example, some logic in a module may be implemented by a programmed general-purpose processing device, while other logic in a module may be implemented by an application-specific integrated circuit (ASIC). In another example, different ones of the logic elements in a module may be associated with different sets of instructions executed by one or more processing devices. A module can omit one or more of the logic elements depicted in the associated drawings; for example, a module may include a subset of the logic elements depicted in the associated drawings when that module is to perform a subset of the operations discussed herein with reference to that module.

In various embodiments, there can be a scientific instrument corresponding to the scientific instrument module 102. In various aspects, the scientific instrument can be any suitable computerized device that can electronically measure some scientifically-relevant, clinically-relevant, or research-relevant characteristic, property, or attribute of an analytical specimen (e.g., of a known or unknown mixture, compound, or collection of matter). As a non-limiting example, a scientific instrument can be an SEM. In such case, the scientific instrument can capture images of the analytical specimen, so as to measure or determine a surface topography, a surface material composition, or a crystallographic structure of the analytical specimen. As another non-limiting example, a scientific instrument can be a TEM. In such case, the scientific instrument can capture images of the interior of the analytical specimen, so as to measure or determine interior structural details of the analytical specimen. As even another non-limiting example, a scientific instrument can be a dual beam microscope. In such case, the scientific instrument can capture images of the analytical specimen in addition to being able to mill the analytical specimen. As still another non-limiting example, a scientific instrument can be an EELM. In such case, the scientific instrument can capture spectral images of the analytical specimen that show electron energy-loss spectra at respective physical locations of the analytical specimen. As a more general non-limiting example, a scientific instrument can be any suitable type of charged-particle microscope (e.g., some types of microscopes can use beams of non-electron ions to capture images). In various cases, the scientific instrument can be outfitted or equipped with a non-backthinned integration detector.

In various embodiments, the first logic 104 can access an energy integration image of a specimen, where such energy integration image can have been captured or generated by the non-backthinned integration detector of the scientific instrument. More specifically, the first logic 104 can: cause the charged-particle microscope to capture a plurality of preliminary energy integration images of the specimen; assign zeros to pixels in the plurality of preliminary energy integration images whose charged-particle energy intensities fall below a noise threshold, thereby yielding a plurality of floored energy integration images; or perform pixel-wise summing or averaging of the plurality of floored energy integration images, thereby yielding the energy integration image.

In various embodiments, the second logic 106 can count how many charged-particle events (e.g., charged-particle strikes) are represented by respective pixels of the energy integration image, based on rounding cumulative charged-particle energy intensities indicated by respective clusters of pixels to nearest integer multiples of a beam energy of the charged-particle microscope. In various aspects, the second logic 106 can: identify the respective clusters by applying a community detection algorithm to the energy integration image. In various instances, for a first cluster having a first cumulative charged-particle energy intensity, the second logic 106 can: divide the first cumulative charged-particle energy intensity by the beam energy of the charged-particle microscope, thereby yielding a quotient; round the quotient to a nearest integer value, thereby yielding a rounded quotient; and determine that a number of charged-particle events represented by the first cluster is equal to the rounded quotient. In various cases, for a first pixel in the first cluster and having a first integrated charged-particle energy intensity, the second logic 106 can: divide the first integrated charged-particle energy intensity by the first cumulative charged-particle energy intensity, thereby yielding a ratio; multiply the ratio by the rounded quotient, thereby yielding a product; and determine that a number of charged-particle events represented by the first pixel is equal to the product.

Accordingly, the scientific instrument module 102 can facilitate charged-particle counting via non-backthinned integration detectors and beam energy quantization.

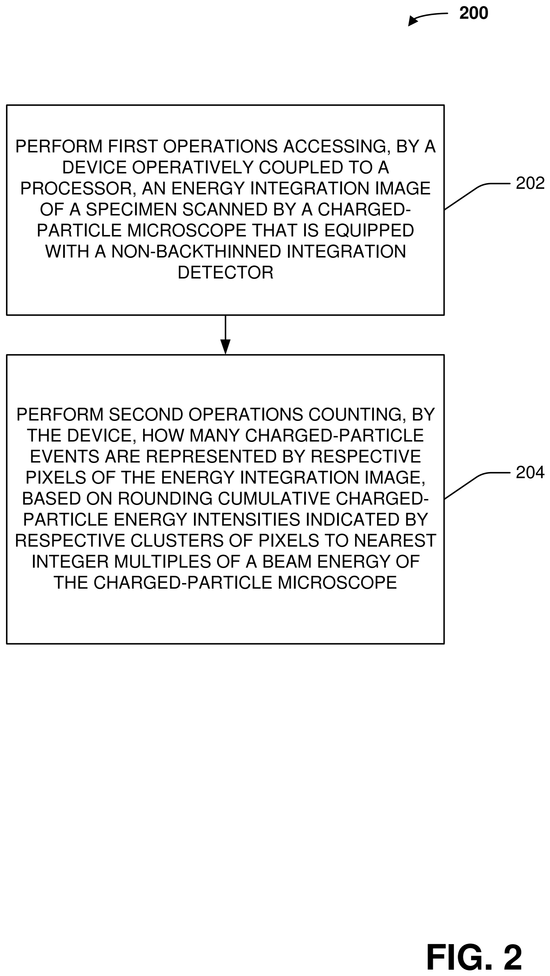

FIG. 2 is an example, non-limiting flow diagram of a computer-implemented method 200 in accordance with various embodiments described herein. The operations of the computer-implemented method 200 may be used in any suitable context to perform any suitable operations (e.g., can be performed by or used in conjunction with any of the various modules, computing devices, or graphical user interfaces described with respect to FIGs. 15-16. Operations are illustrated once each and in a particular order in FIG. 2, but the operations may be reordered or repeated as desired and appropriate (e.g., different operations performed may be performed in parallel, as suitable).

In various aspects, act 202 can include performing first operations accessing, by a device operatively coupled to a processor, an energy integration image of a specimen scanned by a charged-particle microscope that is equipped or outfitted with a non-backthinned integration detector. In various cases, the first logic 104 can perform or otherwise facilitate act 202.

In various aspects, act 204 can include counting, by the device, how many charged-particle events are represented by respective pixels of the energy integration image, based on rounding cumulative charged-particle energy intensities indicated by respective clusters of pixels to nearest integer multiples of a beam energy of the charged-particle microscope. In various cases, the second logic 106 can perform or otherwise facilitate act 204.

Accordingly, the computer-implemented method 200 can facilitate charged-particle counting via non-backthinned integration detectors and beam energy quantization.

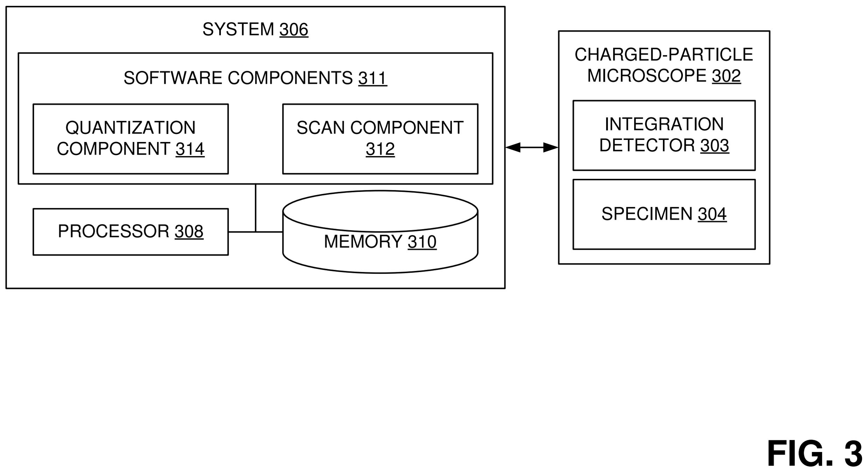

FIG. 3 illustrates a block diagram of an example, non-limiting system that can facilitate charged-particle counting via non-backthinned integration detectors and beam energy quantization in accordance with one or more embodiments described herein.

In various embodiments, there can be a charged-particle microscope 302. In various aspects, the charged-particle microscope 302 can be as described above. That is, the charged-particle microscope 302 can be any suitable computerized device that can leverage its constituent hardware (e.g., electron sources, anodes, condenser lenses, condenser apertures, scan coils, objective lenses, objective apertures, deflectors, condensers, stigmators, electron detectors, X-ray detectors, actuatable specimen stages) to electronically capture any suitable image of any suitable analytical specimen. As a non-limiting example, the charged-particle microscope 302 can be any suitable SEM. As another non-limiting example, the charged-particle microscope 302 can be any suitable TEM. As yet another non-limiting example, the charged-particle microscope 302 can be any suitable dual-beam microscope. As even another non-limiting example, the charged-particle microscope 302 can be any suitable EELM.

In any case, the charged-particle microscope 302 can have, be equipped or outfitted with, or otherwise possess an integration detector 303. In various aspects, the integration detector 303 can be any suitable type of charged-particle detector whose individual cells can measure accumulated (e.g., summed or integrated) energy of whatever charged-particles strike them. As a non-limiting example, the integration detector 303 can be any suitable type of Faraday cup detector. As another non-limiting example, the integration detector 303 can be any suitable type of capacitive detector. As even another non-limiting example, the integration detector 303 can be any suitable type of semiconductor detector, such as a positive-intrinsic-negative (PIN) diode. As yet another non-limiting example, the integration detector 303 can be any suitable type of microchannel plate detector. As still another non-limiting example, the integration detector 303 can be any suitable type of charged-coupled device. In various aspects, the integration detector 303 can be non-backthinned. That is, a thickness of the integration detector 303 can be greater than or equal to a penetration depth of whatever charged-particles that the charged-particle microscope 302 is configured to emit towards the integration detector 303.

Although not explicitly shown, the integration detector 303 can have or otherwise be made up of $p$ cells, for any suitable positive integer $p > 1$. It should be appreciated that the cells of the integration detector 303 can exhibit any suitable regular or irregular shapes, sizes, or arrangements. As a non-limiting example, the cells of the integration detector 303 can be uniform squares that are arranged in a rectilinear, matrix-like layout. As another non-limiting example, the cells of the integration detector 303 can be uniform rectangles that are arranged side-by-side in a single row.

Although not explicitly shown in the figures, the charged-particle microscope 302 can be electronically integrated with any suitable human-computer interface device, which can be remote from or local to the charged-particle microscope 302. Accordingly, a user or technician associated with the charged-particle microscope 302 can interact with or otherwise control the charged-particle microscope 302. Some non-limiting examples of the human-computer interface device can be a keyboard of the charged-particle microscope 302, a keypad of the charged-particle microscope 302, a touchscreen of the charged-particle microscope 302, or a voice-command system of the charged-particle microscope 302.

Although not explicitly shown in the figures, the charged-particle microscope 302 can comprise a plurality of configurable operating settings. In various aspects, each of the plurality of configurable operating settings can be any suitable hardware-related characteristic or software-related characteristic of the charged-particle microscope 302 that can guide, affect, or otherwise dictate how the charged-particle microscope 302 runs, operates, or functions with respect to any given analytical specimen and that can be selectively controlled, changed, adjusted, or otherwise set by the user or technician (e.g., via interaction with the human-computer interface device of the charged-particle microscope 302). As a non-limiting example, any of the plurality of configurable operating settings can be a user-controllable electric voltage setting (e.g., beam voltage) or electric current setting (e.g., beam current), which can allow the user or technician to selectively control an electrode of the charged-particle microscope 302, so as to selectively increase or decrease an electric voltage or electric current within, or that is applied by, the charged-particle microscope 302. As another non-limiting example, any of the plurality of configurable operating settings can be a user-controllable temperature setting, which can allow the user or technician to control a heater (e.g., stage heater, heating coil) or cooler (e.g., cooling fan, heat pump, refrigerator) of the charged-particle microscope 302, so as to selectively increase or decrease a temperature within, or that is applied by, the charged-particle microscope 302. As still another non-limiting example, any of the plurality of configurable operating settings can be a user-controllable mechanical actuator setting, which can allow the user or technician to control a mechanical actuator (e.g., electric motor, specimen stage, iris aperture, fluid pump or syringe) of the charged-particle microscope 302, so as to selectively move the mechanical actuator. As yet another non-limiting example, any of the plurality of configurable operating settings can be a user-controllable optics setting, which can allow the user or technician to control an optical element (e.g., optical lens, optical deflector) of the charged-particle microscope 302, so as to selectively change an optical quality (e.g., focal spot size or location, astigmatism, defocus) that is applied by the charged-particle microscope 302. In any case, beam energy (which may be a function of beam voltage or beam current) can be considered as one of the configurable operating settings of the charged-particle microscope 302.

In various instances, the charged-particle microscope 302 can be loaded with a specimen 304. As a non-limiting example, the specimen 304 can be presently positioned, located, or otherwise affixed onto the specimen stage of the charged-particle microscope 302, such that the specimen 304 is analyzable or scannable by the charged-particle microscope 302. In various cases, the specimen 304 can be any suitable type of synthetic sample or naturally-occurring sample that can exhibit any suitable physical, chemical, compositional, or other properties, attributes, or characteristics. In the case of synthetic specimens, the specimen 304 can be manufactured by any suitable microfabrication or nanofabrication techniques, such as etching, milling, or deposition. As a non-limiting example, the specimen 304 can be a lamella taken from a semiconductor substrate or wafer. As another non-limiting example, the specimen 304 can be any other suitable integrated circuit element or printed circuit board element. However, in the case of naturally-occurring specimens, the specimen 304 can be an organic or biological sample (e.g., a tissue sample).

In various instances, it can be desired to perform charged-particle counting on or with respect to the specimen 304. In various cases, a system 306, which can be electronically integrated (e.g., via any suitable wired or wireless electronic connections) with the charged-particle microscope 302, can accomplish such counting as described herein.

In various aspects, the system 306 can comprise a processor 308 (e.g., computer processing unit, microprocessor) and a non-transitory computer-readable memory 310 that is operably or operatively or communicatively connected or coupled to the processor 308. The non-transitory computer-readable memory 310 can store computer-executable instructions which, upon execution by the processor 308, can cause the processor 308 or other components of the system 306 (e.g., scan component 312, quantization component 314) to perform one or more acts. In various embodiments, the non-transitory computer-readable memory 310 can store computer-executable components (e.g., scan component 312, quantization component 314), and the processor 308 can execute the computer-executable components.

In various embodiments, the system 306 can electronically access the charged-particle microscope 302. That is, the system 306 can electronically communicate or otherwise electronically interact with (e.g., transmit electronic instructions or commands to, receive electronic data from) the charged-particle microscope 302. Accordingly, any components of the system 306 can likewise be able to interact with, communicate with, or otherwise manipulate the charged-particle microscope 302.

In various embodiments, the system 306 can comprise a scan component 312. In various aspects, the scan component 312 can, as described herein, access an energy integration image produced by the charged-particle microscope 302 and corresponding to the specimen 304.

In various embodiments, the system 306 can comprise a quantization component 314. In various instances, the quantization component 314 can, as described herein, identify pixel-wise charged-particle counts based on the energy integration image and based on a beam energy that the charged-particle microscope 302 used to generate the energy integration image.

Note that, in various instances, the scan component 312 and the quantization component 314 can collectively be considered as being one or more software components 311 of the system 306. In various aspects, it should be appreciated that the one or more software components 311 are described primarily herein as comprising two components (e.g., the scan component 312 and the quantization component 314) for ease of explanation and illustration. However, the one or more software components 311 are not limited to being implemented as exactly such two components in every embodiment. Indeed, in some embodiments, the functionalities described herein of such two components can be combined in any suitable fashions, so as to be implemented in or by fewer than two components (e.g., in some cases, a single component can perform all of the functionalities that are described herein with respect to the scan component 312 and the quantization component 314). In other embodiments, the functionalities described herein of such two components can instead be distributed, separated, split, or fragmented in any suitable fashions, so as to be implemented in or by more than two components (e.g., two or more components can facilitate the functionalities that are performable by the scan component 312; two or more components can facilitate the functionalities that are performable by the quantization component 314).

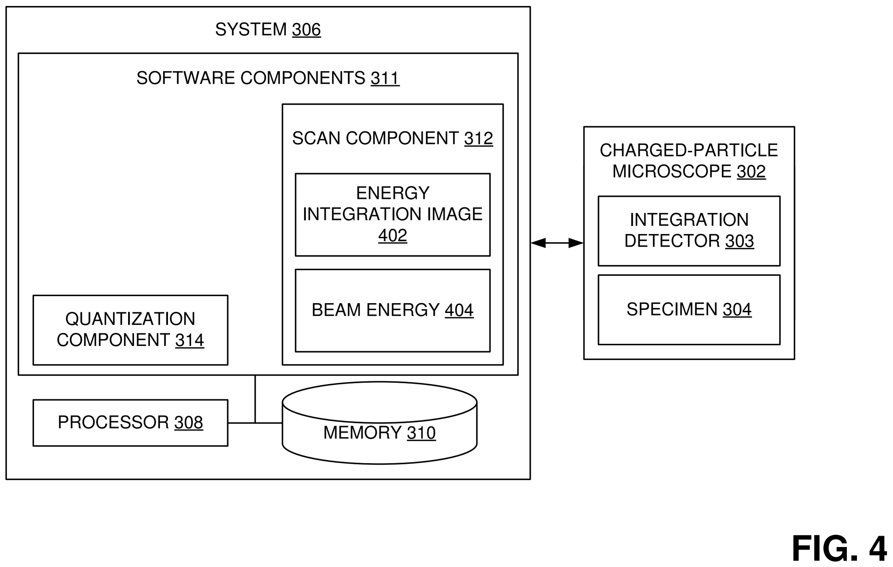

FIG. 4 illustrates a block diagram of an example, non-limiting system including an energy integration image and a beam energy that can facilitate charged-particle counting via non-backthinned integration detectors and beam energy quantization in accordance with one or more embodiments described herein.

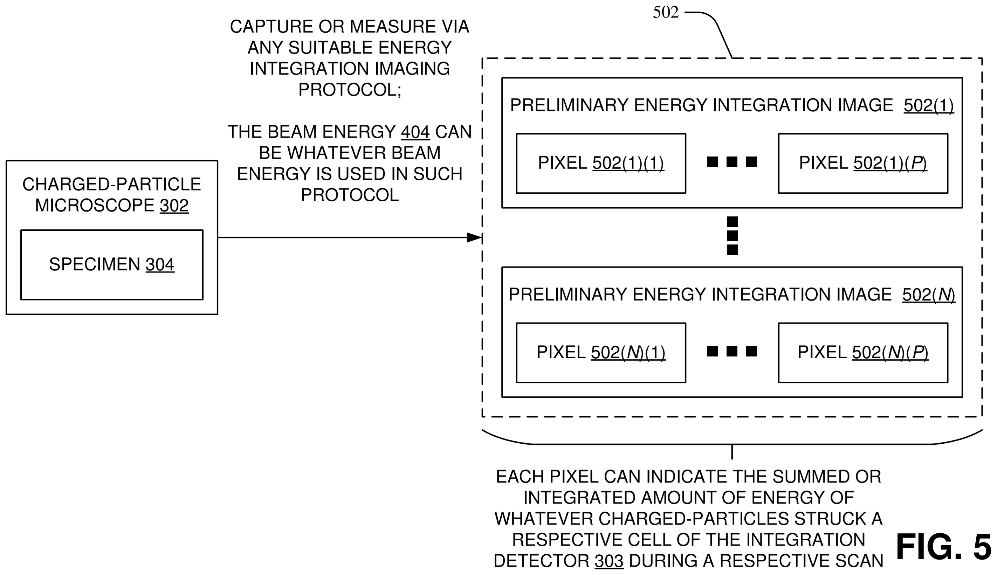

In various embodiments, the scan component 312 can electronically cause the charged-particle microscope 302 to capture or otherwise generate an energy integration image 402 of the specimen 304 according to a beam energy 404. Various non-limiting aspects are described with respect to FIGs. 5-7.

FIGs. 5-7 illustrate example, non-limiting block diagrams showing how the energy integration image 402 can be accessed in accordance with one or more embodiments described herein.

First, consider FIG. 5. In various embodiments, the scan component 312 can electronically instruct or electronically command the charged-particle microscope 302 to perform a plurality of scans on the specimen 304 according to any suitable energy integration imaging protocol. In some aspects, the energy integration imaging protocol can require the configurable operating settings of the charged-particle microscope 302 to have or take on any suitable default values or states. In other aspects, the energy integration imaging protocol can require the configurable operating settings of the charged-particle microscope 302 to have or take on any suitable values or states that are selected by a user of the charged-particle microscope 302 (e.g., selected via the human-computer interface device of the charged-particle microscope 302). In any case, the scan component 312 can cause the charged-particle microscope 302 to perform a plurality of energy integration scans on the specimen 304. Whatever value or state that the beam energy setting of the charged-particle microscope 302 has during or for such plurality of scans can be referred to as the beam energy 404. As a non-limiting example, the beam energy 404 can be 300 keV. In such case, during each of the plurality of scans, the charged-particle microscope 302 can be considered as irradiating or bombarding the specimen 304 with a beam of charged-particles, where each charged-particle in such beam can be considered as having an initial energy of 300 keV (e.g., in reality, some charged-particles in the beam will have slightly more than 300 keV of initial energy, and other charged-particles in the beam will have slightly less than 300 keV of initial energy; but those varying energies can average out to 300 keV).

In various aspects, by performing the plurality of scans on the specimen 304, the charged-particle microscope 302 can electronically capture, generate, or otherwise produce a plurality of preliminary energy integration images 502. In various instances, the plurality of preliminary energy integration images 502 can respectively correspond (e.g., in one-to-one fashion) with the plurality of scans. Suppose that the plurality of scans is made up of $n$ scans, for any suitable positive integer n > 1: a first scan of the specimen 304 to an n-th scan of the specimen 304. In such case, the plurality of preliminary energy integration images 502 can be made up of n images: a preliminary energy integration image 502(1) to a preliminary energy integration image 502(n). Because the integration detector 303 can have $p$ cells, each of the plurality of preliminary energy integration images 502 can be made up of $p$ pixels, where each pixel can indicate a summed or integrated amount of energy of whatever charged-particles struck a respective cell during a respective scan.

As a non-limiting example, the preliminary energy integration image 502(1) can be produced, captured, or generated by the charged-particle microscope 302 during the first scan of the specimen 304. As shown, the preliminary energy integration image 502(1) can be made up of $p$ pixels: a pixel 502(1)(1) to a pixel 502(1)($p$). In various instances, whatever scalar value or magnitude that is indicated by the pixel 502(1)(1) can be considered as representing (e.g., directly in units of eV, or indirectly in arbitrary units) how much summed or integrated energy struck a first cell of the integration detector 303 (and thus passed through a first physical region of the specimen 304) during the first scan. Likewise, whatever scalar value or magnitude that is indicated by the pixel 502(1)($p$) can be considered as representing how much summed or integrated energy struck a p-th cell of the integration detector 303 (and thus passed through a p-th physical region of the specimen 304) during the first scan.

As another non-limiting example, the preliminary energy integration image 502(n) can be produced, captured, or generated by the charged-particle microscope 302 during the n-th scan of the specimen 304. As shown, the preliminary energy integration image 502(n) can be made up of $p$ pixels: a pixel 502(n)(1) to a pixel *502(n)(p)*. In various instances, whatever scalar value or magnitude that is indicated by the pixel 502(n)(1) can be considered as representing (e.g., again, either directly in units of eV, or indirectly in arbitrary units) how much summed or integrated energy struck the first cell of the integration detector 303 (and thus passed through the first physical region of the specimen 304) during the n-th scan. Likewise, whatever scalar value or magnitude that is indicated by the pixel 502(n)(p) can be considered as representing how much summed or integrated energy struck the p-th cell of the integration detector 303 (and thus passed through the p-th physical region of the specimen 304) during the n-th scan.

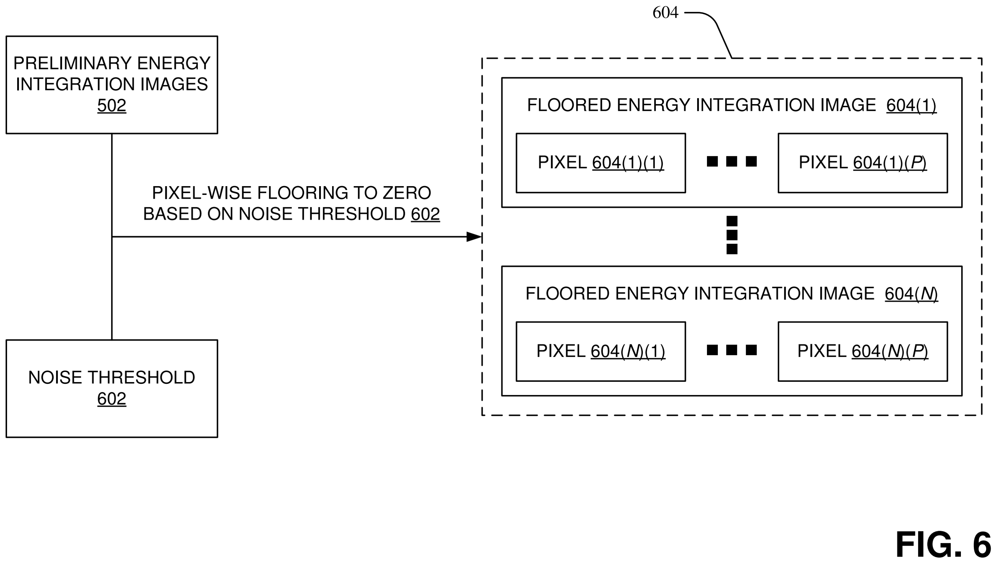

Note that, in low-dose situations (e.g., a charged-particle beam having fewer than $\frac{p}{5}$ charged-particles at a beam energy of 300 keV; or a charged-particle beam having fewer than $\frac{p}{2}$ charged-particles at a beam energy of 60 keV), it can be the case that very many of the plurality of preliminary energy integration images 502 appear to be nothing but noise and that very few of the plurality of preliminary energy integration images 502 have legible, interpretable, or meaningful signal-to-noise ratios. In various cases, the scan component 312 can deal with such noise as shown in FIGs. 6-7.

In various embodiments, as shown in FIG. 6, the scan component 312 can perform conditional pixel-wise flooring (also referred to as conditional pixel-wise masking) on the plurality of preliminary energy integration images 502, based on a noise threshold 602.

In various aspects, the noise threshold 602 can be any suitable scalar whose value or magnitude indicates a maximum level of energy (e.g., represented directly in units of eV, or represented indirectly in arbitrary units, as appropriate) that is known or otherwise deemed to be an upper threshold of noise with respect to the integration detector 303. In other words, when a cell of the integration detector 303 outputs an integrated energy value that is greater than the noise threshold 602, it can be concluded that the cell was struck by at least part of a charged-particle. In contrast, when a cell of the integration detector 303 outputs an integrated energy value that is lesser than the noise threshold 602, it can be concluded that the cell was not struck by any portion of any charged-particle. That is, any integrated signal that is recorded by the integration detector 303 and that is below the noise threshold 602 can be considered as being the result of pure noise. In contrast, any integrated signal that is recorded by the integration detector 303 and that is above the noise threshold 602 can instead be considered as being the result of a charged-particle strike (also referred to as a charged-particle impact or a charged-particle event).

In various aspects, the scan component 312 can electronically floor whichever pixels in the plurality of preliminary energy integration images 502 whose indicated values are below the noise threshold 602. Such conditional flooring can yield a plurality of floored energy integration images 604. In various instances, the plurality of floored energy integration images 604 can respectively correspond (e.g., in one-to-one fashion) to the plurality of preliminary energy integration images 502. Thus, since the plurality of preliminary energy integration images 502 can have n images, the plurality of floored energy integration images 604 can likewise have n images: a floored energy integration image 604(1) to a floored energy integration image 604(n). In various cases, each of the plurality of floored energy integration images 604 can be derived from a respective one of the plurality of preliminary energy integration images 502. Accordingly, each of the plurality of floored energy integration images 604 can have the same number and arrangement of pixels (e.g., $p$) as each of the plurality of preliminary energy integration images 502

As a non-limiting example, the scan component 312 can convert the preliminary energy integration image 502(1) to the floored energy integration image 604(1), and the floored energy integration image 604(1) can thus be made up of $p$ pixels: a pixel 604(1)(1) to a pixel 604(1)(p). More specifically, the scan component 312 can determine whether or not the pixel 502(1)(1) indicates a summed or integrated energy value that is less than the noise threshold 602. If the summed or integrated energy value of the pixel 502(1)(1) is greater than the noise threshold 602, then the scan component 312 can cause the pixel 604(1)(1) to indicate the same summed or integrated energy value as the pixel 502(1)(1). On the other hand, if the summed or integrated energy value of the pixel 502(1)(1) is lesser than the noise threshold 602, then the scan component 312 can instead cause the pixel 604(1)(1) to indicate a summed or integrated energy value of 0. Stated differently, the scan component 312 can floor the pixel 502(1)(1) to 0, in response to the pixel 502(1)(1) being less than the noise threshold 602. In like fashion, the scan component 312 can determine whether or not the pixel 502(1)(p) indicates a summed or integrated energy value that is less than the noise threshold 602. If the summed or integrated energy value of the pixel 502(1)(p) is greater than the noise threshold 602, then the scan component 312 can cause the pixel 604(1)(p) to indicate the same summed or integrated energy value as the pixel 502(1)(p). On the other hand, if the summed or integrated energy value of the pixel 502(1)(p) is lesser than the noise threshold 602, then the scan component 312 can instead cause the pixel 604(1)(p) to indicate a summed or integrated energy value of 0. Just as above, this can be considered as flooring the pixel 502(1)(*p*) to 0, in response to the pixel 502(1)(*p*) being less than the noise threshold 602.

As another non-limiting example, the scan component 312 can convert the preliminary energy integration image 502(n) to the floored energy integration image 604(n), and the floored energy integration image 604(*n*) can thus be made up of *p* pixels: a pixel 604(*n*)(1) to a pixel 604(*n*)(*p*). More specifically, the scan component 312 can determine whether or not the pixel 502(*n*)(1) indicates a summed or integrated energy value that is less than the noise threshold 602. If the summed or integrated energy value of the pixel 502(*n*)(1) is greater than the noise threshold 602, then the scan component 312 can cause the pixel 604(n)(1) to indicate the same summed or integrated energy value as the pixel 502(*n*)(1). On the other hand, if the summed or integrated energy value of the pixel 502(*n*)(1) is lesser than the noise threshold 602, then the scan component 312 can instead cause the pixel 604(*n*)(1) to indicate a summed or integrated energy value of 0. Stated differently, the scan component 312 can floor the pixel 502(*n*)(1) to 0, in response to the pixel 502(*n*)(1) being less than the noise threshold 602. In like fashion, the scan component 312 can determine whether or not the pixel 502(*n*)(p) indicates a summed or integrated energy value that is less than the noise threshold 602. If the summed or integrated energy value of the pixel 502(*n*)(*p*) is greater than the noise threshold 602, then the scan component 312 can cause the pixel 604(*n*)(*p*) to indicate the same summed or integrated energy value as the pixel 502(*n*)(*p*). On the other hand, if the summed or integrated energy value of the pixel 502(*n*)(*p*) is lesser than the noise threshold 602, then the scan component 312 can instead cause the pixel 604(*n*)(*p*) to indicate a summed or integrated energy value of 0. Just as above, this can be considered as flooring the pixel 502(*n*)(*p*) to 0, in response to the pixel 502(*n*)(*p*) being less than the noise threshold 602.

Note that, due to such conditional pixel-wise flooring, it can be the case (e.g., in low-dose situations) that none of the plurality of floored energy integration images 604 appear to be wholly noise. Instead, it can be the case that very many of the plurality of floored energy integration images 604 appear to be completely blank (e.g., black, nothing but zeros) and that very few of the plurality of floored energy integration images 604 can have meaningful, non-zero integrated energy values. In other words, any overwhelming noise that might have been present in the plurality of preliminary energy integration images 502 can be considered as being absent in the plurality of floored energy integration images 604, due to the herein-described conditional pixel-wise flooring.

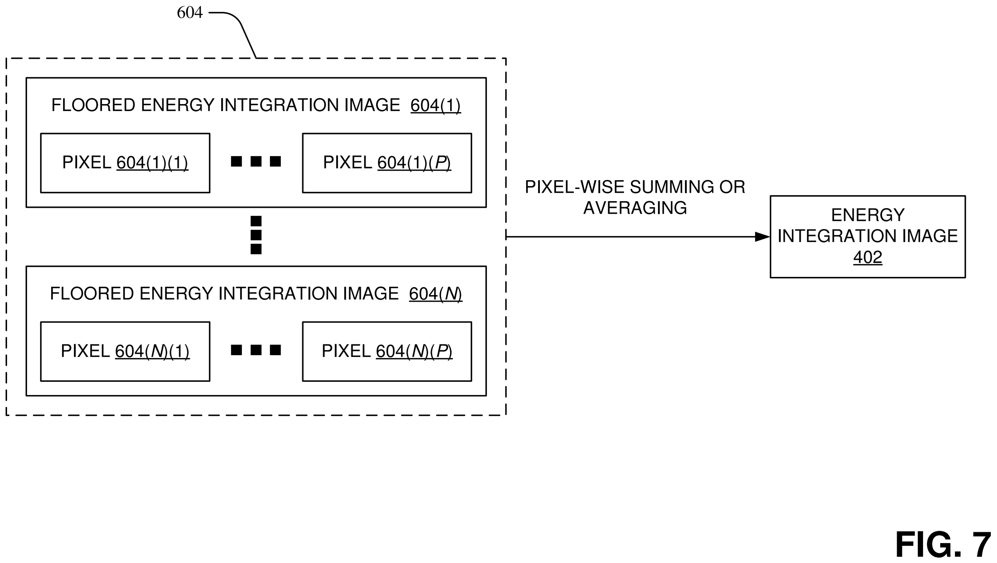

Now, consider FIG. 7. In various embodiments, the scan component 312 can aggregate or otherwise combine the plurality of floored energy integration images 604 together, so as to yield the energy integration image 402. As a non-limiting example, the energy integration image 402 can be equal to or otherwise based on a pixel-wise summation of the plurality of floored energy integration images 604. In such situations, a first pixel of the energy integration image 402 can be equal to a sum of the pixel 604(1)(1) to the pixel 604(*n*)(1), and a *p*-th pixel of the energy integration image 402 can be equal to a sum of the pixel 604(1)(*p*) to the pixel 604(*n*)(*p*). As another non-limiting example, the energy integration image 402 can be equal to or otherwise based on a pixel-wise average of the plurality of floored energy integration images 604. In such situations, the first pixel of the energy integration image 402 can be equal to a mean of the pixel 604(1)(1) to the pixel 604(*n*)(1), and the p-th pixel of the energy integration image 402 can be equal to a mean of the pixel 604(1)(*p*) to the pixel 604(*n*)(*p*). In any case, the energy integration image 402 can be considered as being unaffected by any overwhelming noise that might have been present in the plurality of preliminary energy integration images 502, due to the conditional pixel-wise flooring based on the noise threshold 602.

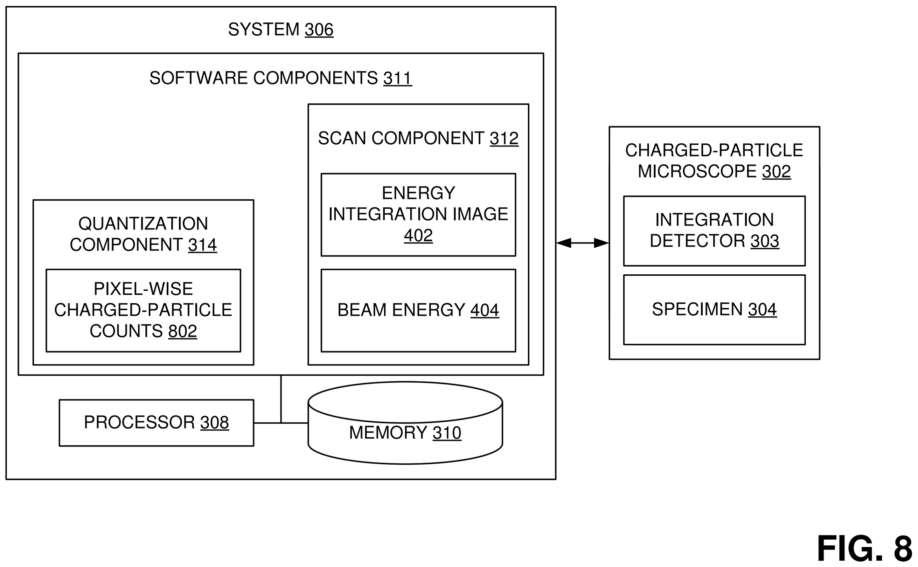

FIG. 8 illustrates a block diagram of an example, non-limiting system including a plurality of pixel-wise charged-particle counts that can facilitate charged-particle counting via non-backthinned integration detectors and beam energy quantization in accordance with one or more embodiments described herein.

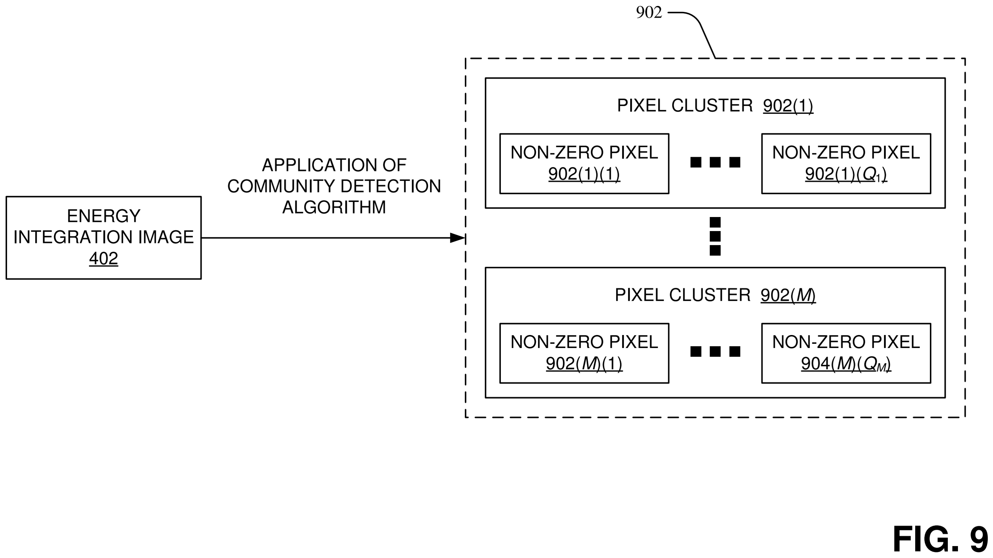

In various embodiments, the quantization component 314 can electronically compute, electronically calculate, or otherwise electronically estimate a plurality of pixel-wise charged-particle counts 802, based on the energy integration image 402 and based on the beam energy 404. Non-limiting aspects are described with respect to FIGs. 9-12.

FIGs. 9-12 illustrate example, non-limiting block diagrams showing how the plurality of pixel-wise charged-particle counts 802 can be determined in accordance with one or more embodiments described herein.

First, consider FIG. 9. In various embodiments, the quantization component 314 can apply any suitable community detection algorithm to the pixels of the energy integration image 402. As a non-limiting example, the community detection algorithm can be a Louvain algorithm. As another non-limiting example, the community detection algorithm can be a Girvan-Newman algorithm. As still another non-limiting example, the community detection algorithm can be a Kernighan-Lin algorithm. As yet another non-limiting example, the community detection algorithm can be a spectral clustering algorithm. As even another non-limiting example, the community detection algorithm can be an infomap algorithm. As another non-limiting example, the community detection algorithm can be a label propagation algorithm. As still another non-limiting example, the community detection algorithm can be an edge betweenness centrality algorithm. As yet another non-limiting example, the community detection algorithm can be a stochastic block model algorithm. As even another non-limiting example, the community detection algorithm can be a clique percolation method algorithm. As another non-limiting example, the community detection algorithm can be a walktrap algorithm. In any case, application of the community detection algorithm to the energy integration image 402 can result in identification of a plurality of pixel clusters 902.

In various embodiments, the plurality of pixel clusters 902 can include m clusters, for any suitable positive integer $m < p$: a pixel cluster 902(1) to a pixel cluster 902(p). In various aspects, each of the plurality of pixel clusters 902 can be a set of pixels of the energy integration image 402 that are adjacent, abutting, or otherwise spatially contiguous with each other and that each indicate non-zero summed or integrated energy values. As a non-limiting example, the pixel cluster 902(1) can be made up of $q_1$ total pixels, for any suitable positive integer $q_1$: a non-zero pixel 902(1)(1) to a non-zero pixel 902(1)($q_1$). As their names suggest, each pixel within the pixel cluster 902(1) can have or exhibit a non-zero summed or integrated energy value or intensity. Moreover, such $q_1$ pixels can form a spatially contiguous set, grouping, or region within the energy integration image 402. In other words, each pixel within the pixel cluster 902(1) can be physically adjacent to, physically abutting, or otherwise a physical neighbor of at least one other pixel within the pixel cluster 902(1). In some cases, no pixel within the pixel cluster 902(1) can be physically adjacent to, physically abutting, or otherwise a physical neighbor of any pixel that belongs to any other of the plurality of pixel clusters 902. As another non-limiting example, the pixel cluster 902(m) can be made up of $q_m$ total pixels, for any suitable positive integer $q_m$: a non-zero pixel 902(m)(1) to a non-zero pixel 902(m)($q_m$). As above, each pixel within the pixel cluster 902(m) can have or exhibit a non-zero summed or integrated energy value or intensity, and such $q_m$ pixels can form a spatially contiguous set, grouping, or region within the energy integration image 402 (e.g., each pixel within the pixel cluster 902(m) can be physically adjacent to, physically abutting, or otherwise a physical neighbor of at least one other pixel within the pixel cluster 902(m); no pixel within the pixel cluster 902(m) can be physically adjacent to, physically abutting, or otherwise a physical neighbor of any pixel that belongs to any other of the plurality of pixel clusters 902).

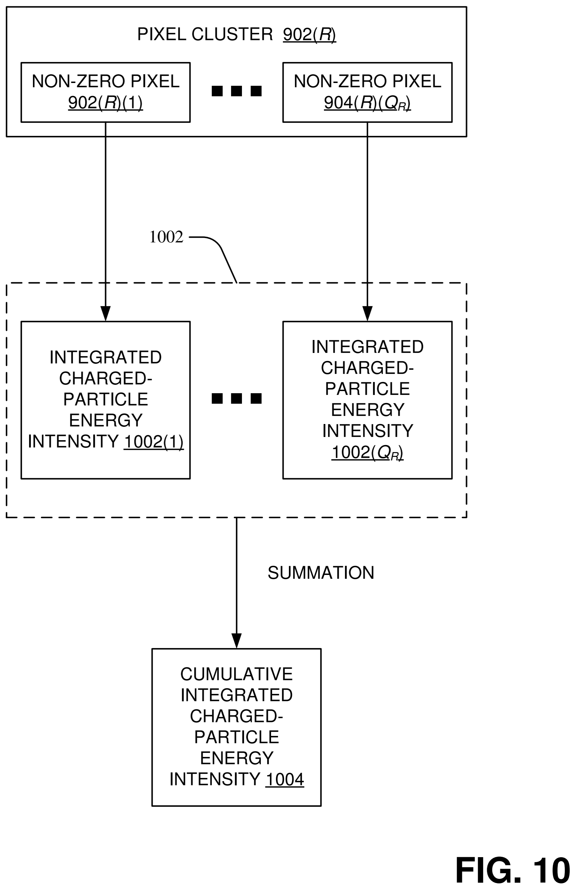

Now, consider FIG. 10, which shows a pixel cluster 902(r) from the plurality of pixel clusters 902, for any suitable positive integer $1 \leq r \leq m$. As shown, the pixel cluster 902(r) can be made up of $q_r$ total pixels, for any suitable positive integer $q_r$: a non-zero pixel 902(r)(1) to a non-zero pixel 902(r)($q_r$).

In various aspects, the pixels of the pixel cluster 902(r) can be considered as collectively indicating a cluster of integrated charged-particle energy intensities 1002. As a non-limiting example, whatever value or magnitude is indicated by the non-zero pixel 902(r)(1) can be referred to as an integrated charged-particle energy intensity 1002(1). As another non-limiting example, whatever value or magnitude is indicated by the non-zero pixel 902(r)($q_r$) can be referred to as an integrated charged-particle energy intensity 1002($q_r$). In various cases, the integrated charged-particle energy intensity 1002(1) to the integrated charged-particle energy intensity 1002($q_r$) can be collectively considered as the cluster of integrated charged-particle energy intensities 1002.

In various instances, the quantization component 314 can sum or add the cluster of integrated charged-particle energy intensities 1002 together. In various aspects, the scalar that results from such summation or addition can be referred to as a cumulative integrated charged-particle energy intensity 1004.

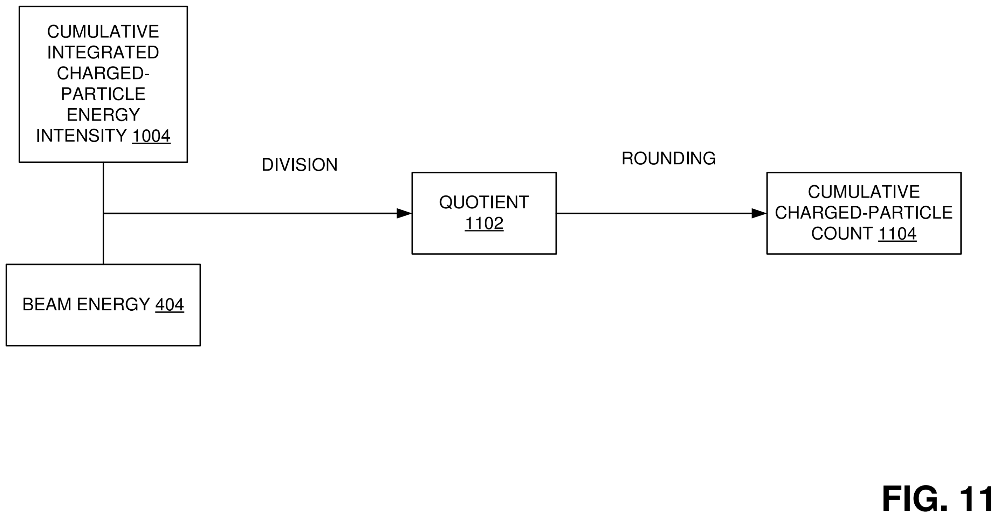

Next, consider FIG. 11. In various embodiments, the quantization component 314 can divide the cumulative integrated charged-particle energy intensity 1004 by the beam energy 404. It should be understood or otherwise appreciated that, in order for such division to be facilitated, the beam energy 404 can be expressed or formatted in the same units as the cumulative integrated charged-particle energy intensity 1004. As a non-limiting example, suppose that the cells of the integration detector 303 directly measure energy in units of eV. In such situations, the beam energy 404 can be likewise expressed in units of eV. As another non-limiting example, suppose that the cells of the integration detector 303 instead indirectly measure energy using arbitrary units that are correlated or mapped to eV. In some such cases, the beam energy 404 can be likewise expressed in such arbitrary units. However, in others of such cases, the beam energy 404 can be expressed in eV, and the cumulative integrated charged-particle energy intensity 1004 can be converted or rewritten into eV.

In any case, dividing the cumulative integrated charged-particle energy intensity 1004 by the beam energy 404 can yield a quotient 1102. In various aspects, the quantization component 314 can numerically round the quotient 1102 to the nearest integer. In various instances, that nearest integer can be referred to as a cumulative charged-particle count 1104. In other words, the cumulative charged-particle count 1104 can be equal to or otherwise based on the following expression:

$$\mathrm{round}\left(\frac{\sum_{i=1}^{q_r} E_i}{B}\right)$$

where $i$ is a summation index, where $E_i$ represents the integrated charged-particle energy intensity of the $i$-th pixel in the pixel cluster 902(r), and where $B$ represents the beam energy 404. In any case, because the integration detector 303 can be non-backthinned, the cumulative charged-particle count 1104 can be an integer that represents how many charged-particles in total struck any of the cells of the integration detector 303 that correspond to (e.g., that store their integrated energy values in) the pixel cluster 902(r).

Note that the cumulative charged-particle count 1104 can be computed, even if two or more of the charged-particles that struck the cells corresponding to the pixel cluster 902($r$) occurred simultaneously, occurred in quick succession, or otherwise piled-up within the same sampling iteration as each other. That is, an accuracy of the cumulative charged-particle count 1104 can be considered as being undiminished or undegraded by the pile-up effect.

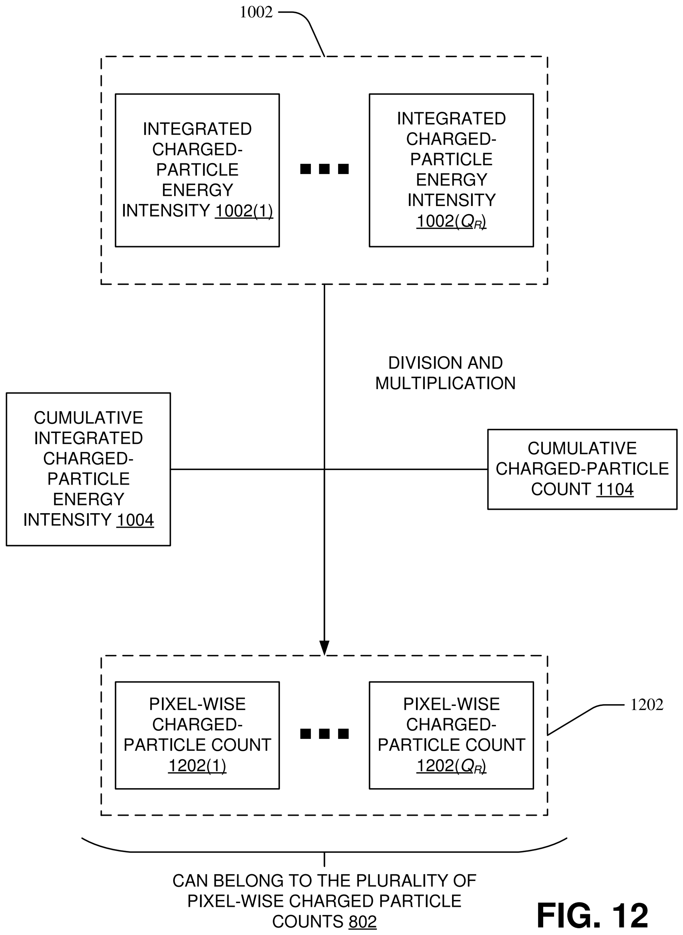

Now, consider FIG. 12. In various embodiments, the quantization component 314 can compute or calculate a set of pixel-wise charged-particle counts 1202, based on the cluster of integrated charged-particle energy intensities 1002, based on the cumulative integrated charged-particle energy intensity 1004, and based on the cumulative charged-particle count 1104. Specifically, for each given integrated charged-particle energy intensity in the cluster of integrated charged-particle energy intensities 1002, the quantization component 314 can: divide that given integrated charged-particle energy intensity by the cumulative integrated charged-particle energy intensity 1004, thereby yielding a ratio; and multiply that ratio by the cumulative charged-particle count 1104. The result of such multiplication can be a respective one of the set of pixel-wise charged-particle counts 1202.

As a non-limiting example, consider the integrated charged-particle energy intensity 1002(1). In various aspects, the quantization component 314 can compute a first ratio, by dividing the integrated charged-particle energy intensity 1002(1) by the cumulative integrated charged-particle energy intensity 1004. Moreover, in various instances, the quantization component 314 can multiply that first ratio by the cumulative charged-particle count 1104, thereby yielding a first product. In various cases, that first product can be referred to as a pixel-wise charged-particle count 1202(1). In various aspects, the pixel-wise charged-particle count 1202(1) can be a scalar whose value or magnitude indicates how many charged-particles struck whatever individual cell of the integration detector 303 that corresponds to (e.g., that stores its integrated energy measurements in) the non-zero pixel 902($r$)(1). Note that the pixel-wise charged-particle count 1202(1) might not be an integer, since it is possible for any charged-particle to straddle two or more cells at the moment that it strikes the integration detector 303 (e.g., it is possible that 30% of a charged-particle struck a first cell and that the remaining 70% of the charged-particle struck a neighboring cell).

As another non-limiting example, consider the integrated charged-particle energy intensity 1002($q_r$). In various aspects, the quantization component 314 can compute a $q_r$-th ratio, by dividing the integrated charged-particle energy intensity 1002($q_r$) by the cumulative integrated charged-particle energy intensity 1004. Moreover, in various instances, the quantization component 314 can multiply that $q_r$-th ratio by the cumulative charged-particle count 1104, thereby yielding a $q_r$-th

product. In various cases, that $q_r$-th product can be referred to as a pixel-wise charged-particle count 1202($q_r$). In various aspects, the pixel-wise charged-particle count 1202($q_r$) can be a scalar whose value or magnitude indicates how many charged-particles struck whatever individual cell of the integration detector 303 that corresponds to (e.g., that stores its integrated energy measurements in) the non-zero pixel 902($r$)($q_r$). As above, the pixel-wise charged-particle count 1202($q_r$) might not be an integer, since it is possible for any charged-particle to straddle two or more cells at the moment that it strikes the integration detector 303.

In various cases, the pixel-wise charged-particle count 1202(1) to the pixel-wise charged-particle count 1202($q_r$) can be collectively considered as forming the set of pixel-wise charged-particle counts 1202. In various aspects, the set of pixel-wise charged-particle counts 1202 can be considered as belonging to or as at least partially making up the plurality of pixel-wise charged-particle counts 802. Note that, since the cumulative charged-particle count 1104 can be undegraded by the pile-up effect, each of the set of pixel-wise charged-particle counts 1202 can likewise be considered as being undegraded by the pile-up effect.

In various embodiments, the quantization component 314 can repeat the above operations described with respect to FIGs. 9-12 for each of the plurality of pixel clusters 902. By performing such operations for each of the plurality of pixel clusters 902, the quantization component 314 can fully populate, fully compute, or fully calculate the plurality of pixel-wise charged-particle counts 802. In other words, by performing such operations for each of the plurality of pixel clusters 902, the quantization component 314 can determine how many charged-particles strikes or events are represented by each non-zero pixel of the energy integration image 402 (e.g., pixels that have been floored to 0 can be considered as representing 0 charged-particle strikes or events).

In various embodiments, the quantization component 314 can electronically perform any suitable actions based on the plurality of pixel-wise charged-particle counts 1202. As a non-limiting example, the quantization component 314 can electronically render any of the plurality of pixel-wise charged-particle counts 1202 on any suitable computer screen or electronic display. As another non-limiting example, the quantization component 314 can electronically transmit any of the plurality of pixel-wise charged-particle counts 1202 to any other suitable computing device. As yet another non-limiting example, the quantization component 314 can electronically apply any suitable downstream or follow-on analytical technique to any of the plurality of pixel-wise charged-particle counts 1202 (e.g., there might be some processing techniques that are configured to receive as input charged-particle counts and to produce as output compositional or chemical predictions about whatever specimen those charged-particle counts came from).

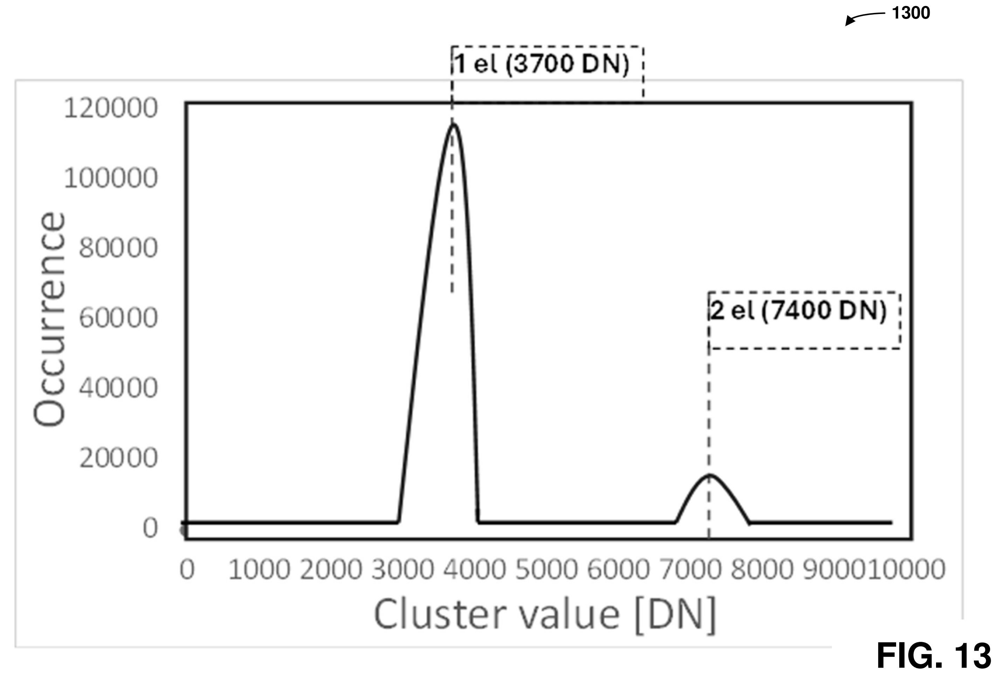

FIGs. 13-14 illustrate experimental results associated with an example, non-limiting implementation of one or more embodiments described herein.

In order to implement various embodiments described herein, the beam energy 404 should be obtained. As mentioned above, the beam energy 404, at least when represented directly in units of eV, can be a controllable, configurable, or otherwise selectable setting or parameter of the charged-particle microscope 302. However, it can often be the case that the integration detector 303 is configured to output measurements in arbitrary units (e.g., such as detector number (D.N.)) rather than in eV units. In those situations, it can initially be unknown how those arbitrary units map or correlate to eV units. So, in such situations, various embodiments described herein can be implemented by first producing a calibration curve which indicates what specific arbitrary unit measurement corresponds to whatever eV value that the beam energy 404 is set to, and quantization can subsequently be performed as described above. Non-limiting aspects of such calibration are described with respect to FIGs. 13-14.

FIG. 13 depicts a calibration curve 1300. The calibration curve 1300 was produced by causing the charged-particle microscope 302, prior to being loaded with the specimen 304, to irradiate the integration detector 303 with the beam energy 404 over the course of a large number of scans (e.g., such that the integration detector 303 ultimately recorded tens of thousands or hundreds of thousands of charged-particle events). For each energy integration image produced during that large number of scans, the pixels of that energy integration image were clustered (as described above), and the cumulative amount of energy indicated in arbitrary units by each cluster was recorded. Those cumulative amounts of energy are represented by the horizontal axis of the calibration curve 1300. The vertical axis of the calibration curve 1300 represents how many clusters obtained during that large number of scans exhibited a respective cumulative energy value. For instance, as can be seen, about 35,000 clusters obtained during that large number of scans exhibited a cumulative energy value just above 500 DN. As another instance, nearly 115,000 clusters obtained during that large number of scans exhibited a cumulative energy value of about 3700 DN. As yet another instance, nearly 10,000 clusters obtained during that large number of scans exhibited a cumulative energy value of about 7400 DN. Note the massive peak at 3700 DN. Note also the subsequent peak at 7400 DN. In situations where the beam energy 404 qualifies as low-dose (e.g., is below any suitable threshold), it can be expected that there will be many more individual charged-particle events (e.g., single-particle strikes) than piled-up events. Because of this expectation, and because 7400 DN is the second multiple of 3700 DN, it can be inferred that a single charged-particle event is associated with 3700 DN. In other words, it can be concluded that, when a single charged-particle having the beam energy 404 strikes a cell of the integration detector 303, it deposits into that cell an amount of energy that causes that cell to output about 3700 DN. Accordingly, two piled-up charged-particles would thus correspond to about 7400 DN (e.g., $2 \times 3700$), three piled-up charged-particles would thus correspond to about 11,100 DN (e.g., $3 \times 3700$), and so on. Note that the portion of the calibration curve that precedes the massive peak at 3700 DN can be considered as primarily the result of noise and thus can be discarded or ignored. So, once it is determined that the beam energy 404 is correlated or mapped (in this non-limiting example) to a detector output of 3700 DN, that detector output of 3700 DN can be utilized in the above-described multiplication and division operations so as to count how many charged-particle strikes or events are represented by the pixels of any desired energy integration image (e.g., by the pixels of the energy integration image 402).

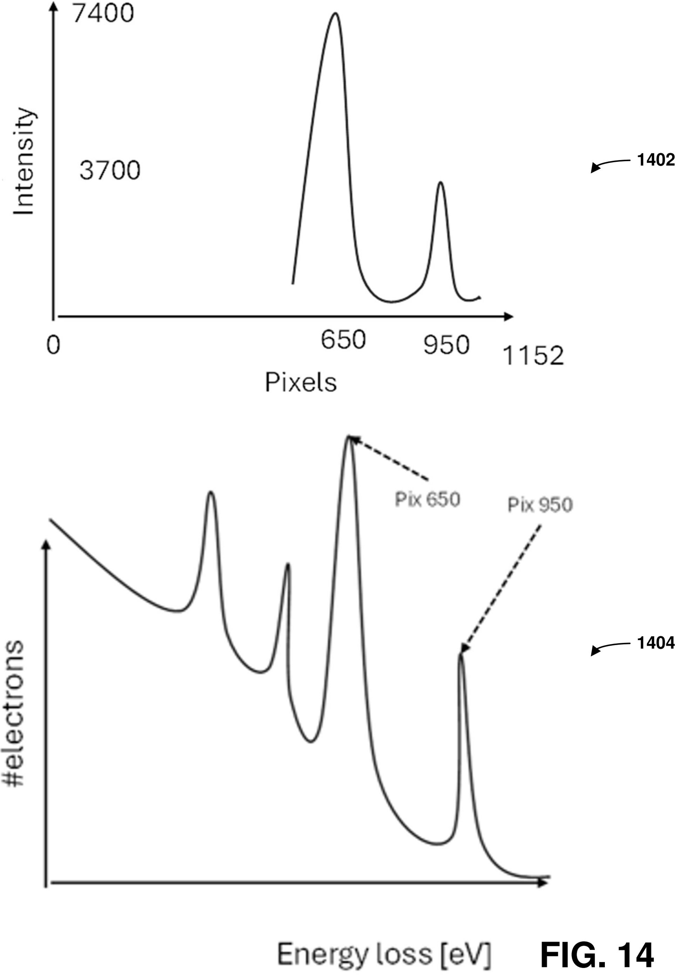

FIG. 14 depicts a graph 1402 and a graph 1404.

The graph 1402 is a non-limiting example of a single acquisition frame captured by the charged-particle microscope 302. The horizontal axis of the graph 1402 represents pixel identifier or pixel index, whereas the vertical axis of the graph 1402 represents intensity indicated by respective pixels in units of D.N. According to the non-limiting example shown in the graph 1402, a $650^{th}$ pixel in whatever energy integration image is represented by the graph 1402 exhibited an energy level of about 7400 D.N., while a $950^{th}$ pixel of that energy integration image instead exhibited an energy level of about 3700 D.N. Thus, it can be concluded that the $650^{th}$ pixel was struck by two charged-particles and that the $950^{th}$ pixel was instead struck by a single charged-particle. As mentioned above, an energy dispersion filter can sometimes be implemented, so that only particles having a specific, uniform, or constant energy-loss are permitted to strike the integration detector 303. So, if an energy dispersion filter were implemented for whatever energy integration image corresponds to the graph 1402, then the two particles that struck the $650^{th}$ pixel and the one particle that struck the $950^{th}$ pixel can all be considered as having the same energy-loss as each other (e.g., as all having whatever energy-loss is permitted or not rejected by the energy dispersion filter). In such case, whatever running particle count corresponds to that energy-loss can be incremented by 3 (e.g., by 2 for the $650^{th}$ pixel, and by 1 for the $950^{th}$ pixel). Note that such incrementing can be done, no matter whether the two particles that struck the $650^{th}$ pixel were piled-up (e.g., occurred in the same sampling iteration as each other). In this way, an accurate particle count that is not impeded by the pile-up effect can be computed for each desired energy-loss level or energy-loss bin.

In various aspects, such energy-loss-wise particle counts can be collectively visually displayed in a separate graph, such as the graph 1404. Specifically, the horizontal axis of the graph 1404 represents energy-loss levels or energy-loss bins, whereas the vertical axis in the graph 1404 represents particle counts for respective energy-loss levels or bins. In the non-limiting example of the graph 1404, the particular charged-particles that are being counted are electrons. In some cases, an energy dispersion filter can be implemented, so as to direct or aim charged-particles having specific energy-losses toward respective pixels (e.g., such that a first pixel can be struck only by particles having a first energy-loss; such that a second pixel can be struck only by particles having a second energy-loss; such that a third pixel can be struck only by particles having a third energy-loss). In such situations, each point in the graph 1404 can be considered as coming from or being populated by whatever data is integrated or accumulated by a respective pixel. A non-limiting example is shown in the graph 1404, where one peak or point can be considered as being derived from the data captured by the 650th pixel and where another peak or point can instead be considered as being derived from the data captured by the 950th pixel.

These experimental results help to demonstrate that various embodiments described herein allow for charged-particles to be counted more accurately or more reliably than existing techniques are able to facilitate. Thus, various embodiments described herein certainly constitute a concrete, tangible technical improvement in the field of charged-particle microscopy.

In various aspects, various embodiments described herein can be implemented in a dual-use charged-particle microscopy scenario. As a non-limiting example, charged-particle counting can be facilitated by the system 306 in a pulse-counting fashion when the beam energy 404 qualifies as high-dose (e.g., is above any suitable threshold), and charged-particle counting can instead be facilitated by the system 306 in the herein-described integration and quantization fashion when the beam energy 404 qualifies as low-dose (e.g., is below any suitable threshold).

In various instances, machine learning algorithms or models can be implemented in any suitable way to facilitate any suitable aspects described herein. To facilitate some of the above-described machine learning aspects of various embodiments, consider the following discussion of artificial intelligence (AI). Various embodiments described herein can employ artificial intelligence to facilitate automating one or more features or functionalities. The components can employ various AI-based schemes for carrying out various embodiments/examples disclosed herein. In order to provide for or aid in the numerous determinations (e.g., determine, ascertain, infer, calculate, predict, prognose, estimate, derive, forecast, detect, compute) described herein, components described herein can examine the entirety or a subset of the data to which it is granted access and can provide for reasoning about or determine states of the system or environment from a set of observations as captured via events or data. Determinations can be employed to identify a specific context or action, or can generate a probability distribution over states, for example. The determinations can be probabilistic; that is, the computation of a probability distribution over states of interest based on a consideration of data and events. Determinations can also refer to techniques employed for composing higher-level events from a set of events or data.

Such determinations can result in the construction of new events or actions from a set of observed events or stored event data, whether or not the events are correlated in close temporal proximity, and whether the events and data come from one or several event and data sources. Components disclosed herein can employ various classification (explicitly trained (e.g., via training data) as well as implicitly trained (e.g., via observing behavior, preferences, historical information, receiving extrinsic information, and so on)) schemes or systems (e.g., support vector machines, neural networks, expert systems, Bayesian belief networks, fuzzy logic, data fusion engines, and so on) in connection with performing automatic or determined action in connection with the claimed subject matter. Thus, classification schemes or systems can be used to automatically learn and perform a number of functions, actions, or determinations.

A classifier can map an input attribute vector, $z = (z_1, z_2, z_3, z_4, z_n)$, to a confidence that the input belongs to a class, as by $f(z) = confidence(class)$. Such classification can employ a probabilistic or statistical-based analysis (e.g., factoring into the analysis utilities and costs) to determinate an action to be automatically performed. A support vector machine (SVM) can be an example of a classifier that can be employed. The SVM operates by finding a hyper-surface in the space of possible inputs, where the hyper-surface attempts to split the triggering criteria from the non-triggering events. Intuitively, this makes the classification correct for testing data that is near, but not identical to training data. Other directed and undirected model classification approaches include, e.g., naïve Bayes, Bayesian networks, decision trees, neural networks, fuzzy logic models, or probabilistic classification models providing different patterns of independence, any of which can be employed. Classification as used herein also is inclusive of statistical regression that is utilized to develop models of priority.

In order to provide additional context for various embodiments described herein, FIG. 15 and the following discussion are intended to provide a brief, general description of a suitable computing environment 1500 in which the various embodiments of the embodiment described herein can be implemented. While the embodiments have been described above in the general context of computer-executable instructions that can run on one or more computers, those skilled in the art will recognize that the embodiments can be also implemented in combination with other program modules or as a combination of hardware and software.

Generally, program modules include routines, programs, components, data structures, etc., that perform particular tasks or implement particular abstract data types. Moreover, those skilled in the art will appreciate that the inventive methods can be practiced with other computer system configurations, including single-processor or multi-processor computer systems, minicomputers, mainframe computers, Internet of Things (IoT) devices, distributed computing systems, as well as personal computers, hand-held computing devices, microprocessor-based or programmable consumer electronics, and the like, each of which can be operatively coupled to one or more associated devices.

The illustrated embodiments of the embodiments herein can be also practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data or unstructured data.

Computer-readable storage media can include, but are not limited to, random access memory (RAM), read only memory (ROM), electrically erasable programmable read only memory (EEPROM), flash memory or other memory technology, compact disk read only memory (CD-ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible or non-transitory media which can be used to store desired information. In this regard, the terms "tangible" or "non-transitory" herein as applied to storage, memory or computer-readable media, are to be understood to exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or direct-wired connection, and wireless media such as acoustic, RF, infrared and other wireless media.

With reference again to FIG. 15, the example environment 1500 for implementing various embodiments of the aspects described herein includes a computer 1502, the computer 1502 including a processing unit 1504, a system memory 1506 and a system bus 1508. The system bus 1508 couples system components including, but not limited to, the system memory 1506 to the processing unit 1504. The processing unit 1504 can be any of various commercially available processors. Dual microprocessors and other multi-processor architectures can also be employed as the processing unit 1504.

The system bus 1508 can be any of several types of bus structure that can further interconnect to a memory bus (with or without a memory controller), a peripheral bus, and a local bus using any of a variety of commercially available bus architectures. The system memory 1506 includes ROM 1510 and RAM 1512. A basic input/output system (BIOS) can be stored in a non-volatile memory such as ROM, erasable programmable read only memory (EPROM), EEPROM, which BIOS contains the basic routines that help to transfer information between elements within the computer 1502, such as during startup. The RAM 1512 can also include a high-speed RAM such as static RAM for caching data.

The computer 1502 further includes an internal hard disk drive (HDD) 1514 (e.g., EIDE, SATA), one or more external storage devices 1516 (e.g., a magnetic floppy disk drive (FDD) 1516, a memory stick or flash drive reader, a memory card reader, etc.) and a drive 1520, e.g., such as a solid state drive, an optical disk drive, which can read or write from a disk 1522, such as a CD-ROM disc, a DVD, a BD, etc. Alternatively, where a solid state drive is involved, disk 1522 would not be included, unless separate. While the internal HDD 1514 is illustrated as located within the computer 1502, the internal HDD 1514 can also be configured for external use in a suitable chassis (not shown). Additionally, while not shown in environment 1500, a solid state drive (SSD) could be used in addition to, or in place of, an HDD 1514. The HDD 1514, external storage device(s) 1516 and drive 1520 can be connected to the system bus 1508 by an HDD interface 1524, an external storage interface 1526 and a drive interface 1528, respectively. The interface 1524 for external drive implementations can include at least one or both of Universal Serial Bus (USB) and Institute of Electrical and Electronics Engineers (IEEE) 1394 interface technologies. Other external drive connection technologies are within contemplation of the embodiments described herein.

The drives and their associated computer-readable storage media provide nonvolatile storage of data, data structures, computer-executable instructions, and so forth. For the computer 1502, the drives and storage media accommodate the storage of any data in a suitable digital format. Although the description of computer-readable storage media above refers to respective types of storage devices, it should be appreciated by those skilled in the art that other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 1512, including an operating system 1530, one or more application programs 1532, other program modules 1534 and program data 1536. All or portions of the operating system, applications, modules, or data can also be cached in the RAM 1512. The systems and methods described herein can be implemented utilizing various commercially available operating systems or combinations of operating systems.

Computer 1502 can optionally comprise emulation technologies. For example, a hypervisor (not shown) or other intermediary can emulate a hardware environment for operating system 1530, and the emulated hardware can optionally be different from the hardware illustrated in FIG. 15. In such an embodiment, operating system 1530 can comprise one virtual machine (VM) of multiple VMs hosted at computer 1502. Furthermore, operating system 1530 can provide runtime environments, such as the Java runtime environment or the .NET framework, for applications 1532. Runtime environments are consistent execution environments that allow applications 1532 to run on any operating system that includes the runtime environment. Similarly, operating system 1530 can support containers, and applications 1532 can be in the form of containers, which are lightweight, standalone, executable packages of software that include, e.g., code, runtime, system tools, system libraries and settings for an application.

Further, computer 1502 can be enable with a security module, such as a trusted processing module (TPM). For instance with a TPM, boot components hash next in time boot components, and wait for a match of results to secured values, before loading a next boot component. This process can take place at any layer in the code execution stack of computer 1502, e.g., applied at the application execution level or at the operating system (OS) kernel level, thereby enabling security at any level of code execution.

A user can enter commands and information into the computer 1502 through one or more wired/wireless input devices, e.g., a keyboard 1538, a touch screen 1540, and a pointing device, such as a mouse 1542. Other input devices (not shown) can include a microphone, an infrared (IR) remote control, a radio frequency (RF) remote control, or other remote control, a joystick, a virtual reality controller or virtual reality headset, a game pad, a stylus pen, an image input device, e.g., camera(s), a gesture sensor input device, a vision movement sensor input device, an emotion or facial detection device, a biometric input device, e.g., fingerprint or iris scanner, or the like. These and other input devices are often connected to the processing unit 1504 through an input device interface 1544 that can be coupled to the system bus 1508, but can be connected by other interfaces, such as a parallel port, an IEEE 1394 serial port, a game port, a USB port, an IR interface, a BLUETOOTH® interface, etc.

A monitor 1546 or other type of display device can be also connected to the system bus 1508 via an interface, such as a video adapter 1548. In addition to the monitor 1546, a computer typically includes other peripheral output devices (not shown), such as speakers, printers, etc.

The computer 1502 can operate in a networked environment using logical connections via wired or wireless communications to one or more remote computers, such as a remote computer(s) 1550. The remote computer(s) 1550 can be a workstation, a server computer, a router, a personal computer, portable computer, microprocessor-based entertainment appliance, a peer device or other common network node, and typically includes many or all of the elements described relative to the computer 1502, although, for purposes of brevity, only a memory/storage device 1552 is illustrated. The logical connections depicted include wired/wireless connectivity to a local area network (LAN) 1554 or larger networks, e.g., a wide area network (WAN) 1556. Such LAN and WAN networking environments are commonplace in offices and companies, and facilitate enterprise-wide computer networks, such as intranets, all of which can connect to a global communications network, e.g., the Internet.

When used in a LAN networking environment, the computer 1502 can be connected to the local network 1554 through a wired or wireless communication network interface or adapter 1558. The adapter 1558 can facilitate wired or wireless communication to the LAN 1554, which can also include a wireless access point (AP) disposed thereon for communicating with the adapter 1558 in a wireless mode.

When used in a WAN networking environment, the computer 1502 can include a modem 1560 or can be connected to a communications server on the WAN 1556 via other means for establishing communications over the WAN 1556, such as by way of the Internet. The modem 1560, which can be internal or external and a wired or wireless device, can be connected to the system bus 1508 via the input device interface 1544. In a networked environment, program modules depicted relative to the computer 1502 or portions thereof, can be stored in the remote memory/storage device 1552. It will be appreciated that the network connections shown are example and other means of establishing a communications link between the computers can be used.

When used in either a LAN or WAN networking environment, the computer 1502 can access cloud storage systems or other network-based storage systems in addition to, or in place of, external storage devices 1516 as described above, such as but not limited to a network virtual machine providing one or more aspects of storage or processing of information. Generally, a connection between the computer 1502 and a cloud storage system can be established over a LAN 1554 or WAN 1556 e.g., by the adapter 1558 or modem 1560, respectively. Upon connecting the computer 1502 to an associated cloud storage system, the external storage interface 1526 can, with the aid of the adapter 1558 or modem 1560, manage storage provided by the cloud storage system as it would other types of external storage. For instance, the external storage interface 1526 can be configured to provide access to cloud storage sources as if those sources were physically connected to the computer 1502.

The computer 1502 can be operable to communicate with any wireless devices or entities operatively disposed in wireless communication, e.g., a printer, scanner, desktop or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH® wireless technologies. Thus, the communication can be a predefined structure as with a conventional network or simply an ad hoc communication between at least two devices.

FIG. 16 is a schematic block diagram of a sample computing environment 1600 with which the disclosed subject matter can interact. The sample computing environment 1600 includes one or more client(s) 1610. The client(s) 1610 can be hardware or software (e.g., threads, processes, computing devices). The sample computing environment 1600 also includes one or more server(s) 1630. The server(s) 1630 can also be hardware or software (e.g., threads, processes, computing devices). The servers 1630 can house threads to perform transformations by employing one or more embodiments as described herein, for example. One possible communication between a client 1610 and a server 1630 can be in the form of a data packet adapted to be transmitted between two or more computer processes. The sample computing environment 1600 includes a communication framework 1650 that can be employed to facilitate communications between the client(s) 1610 and the server(s) 1630. The client(s) 1610 are operably connected to one or more client data store(s) 1620 that can be employed to store information local to the client(s) 1610. Similarly, the server(s) 1630 are operably connected to one or more server data store(s) 1640 that can be employed to store information local to the servers 1630.

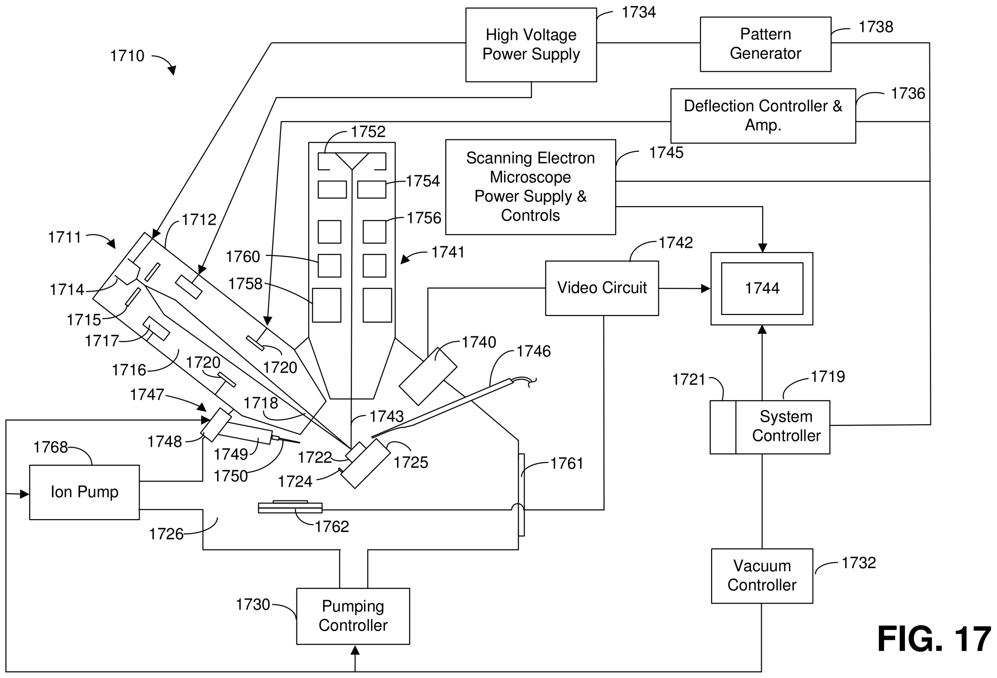

An example, non-limiting apparatus for performing various embodiments described herein is shown in FIG. 17. FIG. 17 illustrates a non-limiting example of a dual beam system 1710 with a vertically mounted scanning electron microscope (SEM) column and a focused ion beam (FIB) column mounted at an angle of approximately 52 degrees from the vertical. Such dual beam systems are commercially available, for example, from FEI Company, Hillsboro, Oregon, the assignee of the present application. While FIG. 17 shows an example of suitable microscopy hardware with which various embodiments described herein can be implemented, it is to be appreciated that such microscopy hardware is non-limiting. In other words, various embodiments described herein can be implemented in conjunction with any other suitable types of microscopy hardware. The dual beam system 1710 is a non-limiting example of the charged-particle microscope 302 or of any other scientific instruments discussed above.

A scanning electron microscope 1741, along with a power supply and control unit 1745, can be provided with the dual beam system 1710. An electron beam 1743 can be emitted from a cathode 1752 by applying voltage between the cathode 1752 and an anode 1754. The electron beam 1743 can be focused to a fine spot by means of a condensing lens 1756 and an objective lens 1758. The electron beam 1743 can be scanned two-dimensionally on any suitable specimen by means of a deflection coil 1760. Operation of the condensing lens 1756, the objective lens 1758, or the deflection coil 1760 can be controlled by the power supply and control unit 1745.

The electron beam 1743 can be focused onto a substrate 1722, which can be on a movable X-Y stage 1725 within a lower chamber 1726. When the electrons in the electron beam 1743 strike the substrate 1722, secondary electrons can be emitted. These secondary electrons can be detected by a secondary electron detector 1740 as discussed below. A scanning transmission electron microscopy (STEM) detector 1762, located beneath a transmission electron microscopy (TEM) sample holder 1724 and the movable X-Y stage 1725, can collect electrons that are transmitted through the sample mounted on the TEM sample holder 1724 as discussed above.

The dual beam system 1710 can also include a focused ion beam (FIB) system 1711 which can comprise an evacuated chamber having an upper neck portion 1712 within which can be located an ion source 1714 and a focusing column 1716 including extractor electrodes and an electrostatic optical system. The axis of the focusing column 1716 can be tilted 52 degrees (or any other suitable angular displacement) from the axis of the electron column. The ion column 1712 can include an ion source 1714, an extraction electrode 1715, a focusing element 1717, deflection elements 1720, and a focused ion beam 1718. The focused ion beam 1718 can pass from the ion source 1714 through the focusing column 1716 and between electrostatic deflection means schematically indicated at numeral 1720 toward the substrate 1722, which can comprise, for example, a semiconductor device positioned on the movable X-Y stage 1725 within the lower chamber 1726.

The movable X-Y stage 1725 can move in a horizontal plane (along X and Y axes) and vertically (along Z axis). The movable X-Y stage 1725 can tilt approximately sixty (60) degrees and rotate about the Z axis. In some embodiments, a separate TEM sample stage (not shown) can be used. Such a TEM sample stage can be moveable in the X, Y, and Z axes. A door 1761 can be opened for inserting the substrate 1722 onto the movable X-Y stage 1725 or also for servicing an internal gas supply reservoir, if one is used. The door 1761 can be interlocked so that it cannot be opened if the system is under vacuum.

An ion pump 1768 can be employed for evacuating the neck portion 1712. The chamber 1726 can be evacuated with a turbomolecular and mechanical pumping system 1730 under the control of a vacuum controller 1732. Such vacuum system can provide within the chamber 1726 a vacuum of between approximately $1 \times 10^{-7}$ Torr and $5 \times 10^{-4}$ Torr. If an etch assisting, an etch retarding gas, or a deposition precursor gas is used, the chamber background pressure may rise, typically to about $1 \times 10^{-5}$ Torr.

A high voltage power supply 1734 can provide an appropriate acceleration voltage to electrodes in the focusing column 1716 for energizing and the focused ion beam 1718. When it strikes the substrate 1722, material can be sputtered (that is, physically ejected) from the sample. Alternatively, the focused ion beam 1718 can decompose a precursor gas to deposit a material.

The high voltage power supply 1734 can be connected to the ion source 1714 (which can be a liquid metal ion source) as well as to appropriate electrodes in the ion beam focusing column 1716 for forming an approximately 1 keV to 60 keV ion beam 1718 and directing the same toward a sample. A deflection controller and amplifier 1736, operated in accordance with a prescribed pattern provided by a pattern generator 1738, can be coupled to the deflection elements 1720 (which can be deflection plates) whereby the focused ion beam 1718 may be controlled manually or automatically to trace out a corresponding pattern on the upper surface of the substrate 1722. In some systems, the deflection elements 1720 can be placed before the final lens. Beam blanking electrodes (not shown) within the ion beam focusing column 1716 can cause the focused ion beam 1718 to impact onto a blanking aperture (not shown) instead of the substrate 1722 when a blanking controller (not shown) applies a blanking voltage to a blanking electrode.

The ion source 1714 can provide a metal ion beam of gallium, for example. In other examples, the ion source 1714 may be a plasma ion source that extracts ions from a generated plasma. The source can be capable of being focused into a sub one-tenth micrometer wide beam at the substrate 1722 for either modifying the substrate 1722 by ion milling, enhanced etch, material deposition, or for the purpose of imaging the substrate 1722.

A charged particle detector 1740, such as an Everhart Thornley or multichannel plate, used for detecting secondary ion or electron emission can be connected to a video circuit 1742 that can supply drive signals to a video monitor 1744 and receive deflection signals from a system controller 1719. The location of the charged particle detector 1740 within the lower chamber 1726 can vary in different embodiments. For example, the charged particle detector 1740 can be coaxial with the ion beam and include a hole for allowing the ion beam to pass. In other embodiments, secondary particles can be collected through a final lens and then diverted off axis for collection.

A micromanipulator 1747 can precisely move objects within the vacuum chamber. The micromanipulator 1747 may comprise precision electric motors 1748 positioned outside the vacuum chamber to provide X, Y, Z, and theta control of a portion 1749 positioned within the vacuum chamber. The micromanipulator 1747 can be fitted with different end effectors for manipulating small objects. In various embodiments described herein, the end effector can be a thin probe 1750.

A gas delivery system 1746 can extend into the lower chamber 1726 for introducing and directing a gaseous vapor toward the substrate 1722. U.S. Pat. No. 5,851,413 to Casella et al. for "Gas Delivery Systems for Particle Beam Processing," assigned to the assignee of the present invention, describes a suitable gas delivery system 1746. Another gas delivery system is described in U.S. Pat. No. 5,435,850 to Rasmussen for a "Gas Injection System," also assigned to the assignee of the present invention. For example, iodine can be delivered to enhance etching, or a metal organic compound can be delivered to deposit a metal.

The system controller 1719 can control the operations of the various parts of the dual beam system 1710. Through the system controller 1719, a user can cause the focused ion beam 1718 or the electron beam 1743 to be scanned in a desired manner through commands entered into any suitable user interface (not shown). Alternatively, the system controller 1719 may control the dual beam system 1710 in accordance with programmed instructions stored in a memory 1721. In various embodiments, any of the one or more software components 311 can be implemented in or otherwise executed by the system controller 1719.

Various embodiments may be a system, a method, an apparatus or a computer program product at any possible technical detail level of integration. The computer program product can include a computer readable storage medium (or media) having computer readable program instructions thereon for causing a processor to carry out aspects of various embodiments. The computer readable storage medium can be a tangible device that can retain and store instructions for use by an instruction execution device. The computer readable storage medium can be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium can also include the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network or a wireless network. The network can comprise copper transmission cables, optical transmission fibers, wireless transmission, routers, firewalls, switches, gateway computers or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of various embodiments can be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions can execute entirely on the user's computer, partly on the user's computer, as a stand-alone software package, partly on the user's computer and partly on a remote computer or entirely on the remote computer or server. In the latter scenario, the remote computer can be connected to the user's computer through any type of network, including a local area network (LAN) or a wide area network (WAN), or the connection can be made to an external computer (for example, through the Internet using an Internet Service Provider). In some embodiments, electronic circuitry including, for example, programmable logic circuitry, field-programmable gate arrays (FPGA), or programmable logic arrays (PLA) can execute the computer readable program instructions by utilizing state information of the computer readable program instructions to personalize the electronic circuitry, in order to perform various aspects.

Various aspects are described herein with reference to flowchart illustrations or block diagrams of methods, apparatus (systems), and computer program products according to various embodiments. It will be understood that each block of the flowchart illustrations or block diagrams, and combinations of blocks in the flowchart illustrations or block diagrams, can be implemented by computer readable program instructions. These computer readable program instructions can be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart or block diagram block or blocks. These computer readable program instructions can also be stored in a computer readable storage medium that can direct a computer, a programmable data processing apparatus, or other devices to function in a particular manner, such that the computer readable storage medium having instructions stored therein comprises an article of manufacture including instructions which implement aspects of the function/act specified in the flowchart or block diagram block or blocks. The computer readable program instructions can also be loaded onto a computer, other programmable data processing apparatus, or other device to cause a series of operational acts to be performed on the computer, other programmable apparatus or other device to produce a computer implemented process, such that the instructions which execute on the computer, other programmable apparatus, or other device implement the functions/acts specified in the flowchart or block diagram block or blocks.

The flowcharts and block diagrams in the Figures illustrate the architecture, functionality, and operation of possible implementations of systems, methods, and computer program products according to various embodiments. In this regard, each block in the flowchart or block diagrams can represent a module, segment, or portion of instructions, which comprises one or more executable instructions for implementing the specified logical function(s). In some alternative implementations, the functions noted in the blocks can occur out of the order noted in the Figures. For example, two blocks shown in succession can, in fact, be executed substantially concurrently, or the blocks can sometimes be executed in the reverse order, depending upon the functionality involved. It will also be noted that each block of the block diagrams or flowchart illustration, and combinations of blocks in the block diagrams or flowchart illustration, can be implemented by special purpose hardware-based systems that perform the specified functions or acts or carry out combinations of special purpose hardware and computer instructions.

While the subject matter has been described above in the general context of computer-executable instructions of a computer program product that runs on a computer or computers, those skilled in the art will recognize that this disclosure also can or can be implemented in combination with other program modules. Generally, program modules include routines, programs, components, data structures, etc. that perform particular tasks or implement particular abstract data types. Moreover, those skilled in the art will appreciate that various aspects can be practiced with other computer system configurations, including single-processor or multiprocessor computer systems, mini-computing devices, mainframe computers, as well as computers, handheld computing devices (e.g., PDA, phone), microprocessor-based or programmable consumer or industrial electronics, and the like. The illustrated aspects can also be practiced in distributed computing environments in which tasks are performed by remote processing devices that are linked through a communications network. However, some, if not all aspects of this disclosure can be practiced on stand-alone computers. In a distributed computing environment, program modules can be located in both local and remote memory storage devices.

As used in this application, the terms "component," "system," "platform," "interface," and the like, can refer to or can include a computer-related entity or an entity related to an operational machine with one or more specific functionalities. The entities disclosed herein can be either hardware, a combination of hardware and software, software, or software in execution. For example, a component can be, but is not limited to being, a process running on a processor, a processor, an object, an executable, a thread of execution, a program, or a computer. By way of illustration, both an application running on a server and the server can be a component. One or more components can reside within a process or thread of execution and a component can be localized on one computer or distributed between two or more computers. In another example, respective components can execute from various computer readable media having various data structures stored thereon. The components can communicate via local or remote processes such as in accordance with a signal having one or more data packets (e.g., data from one component interacting with another component in a local system, distributed system, or across a network such as the Internet with other systems via the signal). As another example, a component can be an apparatus with specific functionality provided by mechanical parts operated by electric or electronic circuitry, which is operated by a software or firmware application executed by a processor. In such a case, the processor can be internal or external to the apparatus and can execute at least a part of the software or firmware application. As yet another example, a component can be an apparatus that provides specific functionality through electronic components without mechanical parts, wherein the electronic components can include a processor or other means to execute software or firmware that confers at least in part the functionality of the electronic components. In an aspect, a component can emulate an electronic component via a virtual machine, e.g., within a cloud computing system.

In addition, the term "or" is intended to mean an inclusive "or" rather than an exclusive "or." That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. As used herein, the term "and/or" is intended to have the same meaning as "or." Moreover, articles "a" and "an" as used in the subject specification and annexed drawings should generally be construed to mean "one or more" unless specified otherwise or clear from context to be directed to a singular form. As used herein, the terms "example" or "exemplary" are utilized to mean serving as an example, instance, or illustration. For the avoidance of doubt, the subject matter disclosed herein is not limited by such examples. In addition, any aspect or design described herein as an "example" or "exemplary" is not necessarily to be construed as preferred or advantageous over other aspects or designs, nor is it meant to preclude equivalent exemplary structures and techniques known to those of ordinary skill in the art.

The herein disclosure describes non-limiting examples. For ease of description or explanation, various portions of the herein disclosure utilize the term "each," "every," or "all" when discussing various examples. Such usages of the term "each," "every," or "all" are non-limiting. In other words, when the herein disclosure provides a description that is applied to "each," "every," or "all" of some particular object or component, it should be understood that this is a non-limiting example, and it should be further understood that, in various other examples, it can be the case that such description applies to fewer than "each," "every," or "all" of that particular object or component.

As it is employed in the subject specification, the term "processor" can refer to substantially any computing processing unit or device comprising, but not limited to, single-core processors; single-processors with software multithread execution capability; multi-core processors; multi-core processors with software multithread execution capability; multi-core processors with hardware multithread technology; parallel platforms; and parallel platforms with distributed shared memory. Additionally, a processor can refer to an integrated circuit, an application specific integrated circuit (ASIC), a digital signal processor (DSP), a field programmable gate array (FPGA), a programmable logic controller (PLC), a complex programmable logic device (CPLD), a discrete gate or transistor logic, discrete hardware components, or any combination thereof designed to perform the functions described herein. Further, processors can exploit nanoscale architectures such as, but not limited to, molecular and quantum-dot based transistors, switches and gates, in order to optimize space usage or enhance performance of user equipment. A processor can also be implemented as a combination of computing processing units. In this disclosure, terms such as "store," "storage," "data store," data storage," "database," and substantially any other information storage component relevant to operation and functionality of a component are utilized to refer to "memory components," entities embodied in a "memory," or components comprising a memory. It is to be appreciated that memory or memory components described herein can be either volatile memory or non-volatile memory, or can include both volatile and non-volatile memory. By way of illustration, and not limitation, nonvolatile memory can include read only memory (ROM), programmable ROM (PROM), electrically programmable ROM (EPROM), electrically erasable ROM (EEPROM), flash memory, or nonvolatile random access memory (RAM) (e.g., ferroelectric RAM (FeRAM). Volatile memory can include RAM, which can act as external cache memory, for example. By way of illustration and not limitation, RAM is available in many forms such as synchronous RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), direct Rambus RAM (DRRAM), direct Rambus dynamic RAM (DRDRAM), and Rambus dynamic RAM (RDRAM). Additionally, the disclosed memory components of systems or computer-implemented methods herein are intended to include, without being limited to including, these and any other suitable types of memory.

What has been described above include mere examples of systems and computer-implemented methods. It is, of course, not possible to describe every conceivable combination of components or computer-implemented methods for purposes of describing this disclosure, but many further combinations and permutations of this disclosure are possible. Furthermore, to the extent that the terms "includes," "has," "possesses," and the like are used in the detailed description, claims, appendices and drawings such terms are intended to be inclusive in a manner similar to the term "comprising" as "comprising" is interpreted when employed as a transitional word in a claim.

The descriptions of the various embodiments have been presented for purposes of illustration, but are not intended to be exhaustive or limited to the embodiments disclosed. Many modifications and variations will be apparent without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

Various non-limiting aspects are described in the following examples.

EXAMPLE 1: A system can comprise: a processor that can execute computer-executable components stored in a non-transitory computer-readable memory, wherein the computer-executable components can comprise: a scan component that can access an energy integration image of a specimen scanned by a charged-particle microscope that can be equipped with a non-backthinned integration detector; and a quantization component that can count how many charged-particle events are represented by respective pixels of the energy integration image, based on rounding cumulative charged-particle energy intensities indicated by respective clusters of pixels to nearest integer multiples of a beam energy of the charged-particle microscope.

EXAMPLE 2: The system of any preceding example can be implemented, wherein the scan component can cause the charged-particle microscope to capture a plurality of preliminary energy integration images of the specimen.

EXAMPLE 3: The system of any preceding example can be implemented, wherein the scan component can assign zeros to pixels in the plurality of preliminary energy integration images whose charged-particle energy intensities fall below a noise threshold, thereby yielding a plurality of floored energy integration images.

EXAMPLE 4: The system of any preceding example can be implemented, wherein the scan component can perform pixel-wise summing or averaging of the plurality of floored energy integration images, thereby yielding the energy integration image.

EXAMPLE 5: The system of any preceding example can be implemented, wherein the quantization component can identify the respective clusters by applying a community detection algorithm to the energy integration image.

EXAMPLE 6: The system of any preceding example can be implemented, wherein, for a first cluster having a first cumulative charged-particle energy intensity, the quantization component can: divide the first cumulative charged-particle energy intensity by the beam energy of the charged-particle microscope, thereby yielding a quotient; round the quotient to a nearest integer value, thereby yielding a rounded quotient; and determine that a number of charged-particle events represented by the first cluster is equal to the rounded quotient.

EXAMPLE 7: The system of any preceding example can be implemented, wherein, for a first pixel in the first cluster and having a first integrated charged-particle energy intensity, the quantization component can: divide the first integrated charged-particle energy intensity by the first cumulative charged-particle energy intensity, thereby yielding a ratio; multiply the ratio by the rounded quotient, thereby yielding a product; and determine that a number of charged-particle events represented by the first pixel is equal to the product.

EXAMPLE 8: The system of any preceding example can be implemented, wherein the charged-particle microscope can be an electron energy-loss microscope.

In various embodiments, any combination or combinations of examples 1-8 can be implemented.

EXAMPLE 9: A computer-implemented method can comprise: accessing, by a device operatively coupled to a processor, an energy integration image of a specimen scanned by a charged-particle microscope that can be equipped with a non-backthinned integration detector; and counting, by the device, how many charged-particle events are represented by respective pixels of the energy integration image, based on rounding cumulative charged-particle energy intensities indicated by respective clusters of pixels to nearest integer multiples of a beam energy of the charged-particle microscope

EXAMPLE 10: The computer-implemented method of any preceding example can be implemented, further comprising: causing, by the device, the charged-particle microscope to capture a plurality of preliminary energy integration images of the specimen.

EXAMPLE 11: The computer-implemented method of any preceding example can be implemented, further comprising: assigning, by the device, zeros to pixels in the plurality of preliminary energy integration images whose charged-particle energy intensities fall below a noise threshold, thereby yielding a plurality of floored energy integration images.

EXAMPLE 12: The computer-implemented method of any preceding example can be implemented, further comprising: performing, by the device, pixel-wise summing or averaging of the plurality of floored energy integration images, thereby yielding the energy integration image.

EXAMPLE 13: The computer-implemented method of any preceding example can be implemented, further comprising: identifying, by the device, the respective clusters by applying a community detection algorithm to the energy integration image.

EXAMPLE 14: The computer-implemented method of any preceding example can be implemented, further comprising, for a first cluster having a first cumulative charged-particle energy intensity: dividing, by the device, the first cumulative charged-particle energy intensity by the beam energy of the charged-particle microscope, thereby yielding a quotient; rounding, by the device, the quotient to a nearest integer value, thereby yielding a rounded quotient; and determining, by the device, that a number of charged-particle events represented by the first cluster is equal to the rounded quotient.

EXAMPLE 15: The computer-implemented method of any preceding example can be implemented, further comprising, for a first pixel in the first cluster and having a first integrated charged-particle energy intensity: dividing, by the device, the first integrated charged-particle energy intensity by the first cumulative charged-particle energy intensity, thereby yielding a ratio; multiplying, by the device, the ratio by the rounded quotient, thereby yielding a product; and determining, by the device, that a number of charged-particle events represented by the first pixel is equal to the product.

EXAMPLE 16: The computer-implemented method of any preceding example can be implemented, wherein the charged-particle microscope can be an electron energy-loss microscope.

In various embodiments, any combination or combinations of examples 9-16 can be implemented.

EXAMPLE 17: A computer program product for facilitating charged-particle counting via non-backthinned integration detectors and beam energy quantization can comprise a non-transitory computer-readable memory having program instructions embodied therewith. In various aspects, the program instructions can be executable by a processor to cause the processor to: access an energy integration image of a specimen scanned by an electron energy-loss microscope that can be equipped with a non-backthinned integration detector; and count how many electron events are represented by respective pixels of the energy integration image, based on rounding cumulative electron energy intensities indicated by respective clusters of pixels to nearest integer multiples of a beam energy of the electron energy-loss microscope.

EXAMPLE 18: The computer program product of any preceding example can be implemented, wherein, the program instructions can be further executable to cause the processor to: cause the electron energy-loss microscope to capture a plurality of preliminary energy integration images of the specimen; assign zeros to pixels in the plurality of preliminary energy integration images whose electron energy intensities fall below a noise threshold, thereby yielding a plurality of floored energy integration images; and perform pixel-wise summing or averaging of the plurality of floored energy integration images, thereby yielding the energy integration image.

EXAMPLE 19: The computer program product of any preceding example can be implemented, wherein, for a first cluster having a first cumulative electron energy intensity, the program instructions can be further executable to cause the processor to: divide the first cumulative electron energy intensity by the beam energy of the electron energy-loss microscope, thereby yielding a quotient; round the quotient to a nearest integer value, thereby yielding a rounded quotient; and determine that a number of electron events represented by the first cluster is equal to the rounded quotient.

EXAMPLE 20: The computer program product of any preceding example can be implemented, wherein, for a first pixel in the first cluster and having a first electron energy intensity, the program instructions can be further executable to cause the processor to: divide the first electron energy intensity by the first cumulative electron energy intensity, thereby yielding a ratio; multiply the ratio by the rounded quotient, thereby yielding a product; and determine that a number of electron events represented by the first pixel is equal to the product.

In various embodiments, any combination or combinations of examples 17-20 can be implemented.

In various embodiments, any combination or combinations of examples 1-20 can be implemented.

## Claims

1. A computer-implemented method, comprising:

    accessing, by a device operatively coupled to a processor, an energy integration image of a specimen scanned by a charged-particle microscope equipped with a non-backthinned integration detector; and
    counting, by the device, how many charged-particle events are represented by respective pixels of the energy integration image, based on rounding cumulative charged-particle energy intensities indicated by respective clusters of pixels to nearest integer multiples of a beam energy of the charged-particle microscope.

2. The computer-implemented method of claim 1, further comprising:
    causing, by the device, the charged-particle microscope to capture a plurality of preliminary energy integration images of the specimen.

3. The computer-implemented method of claim 2, further comprising:
    assigning, by the device, zeros to pixels in the plurality of preliminary energy integration images whose charged-particle energy intensities fall below a noise threshold, thereby yielding a plurality of floored energy integration images.

4. The computer-implemented method of claim 3, further comprising:
    performing, by the device, pixel-wise summing or averaging of the plurality of floored energy integration images, thereby yielding the energy integration image.

5. The computer-implemented method of claim 4, further comprising:
    identifying, by the device, the respective clusters by applying a community detection algorithm to the energy integration image.

6. The computer-implemented method of claim 5, further comprising, for a first cluster having a first cumulative charged-particle energy intensity:

    dividing, by the device, the first cumulative charged-particle energy intensity by the beam energy of the charged-particle microscope, thereby yielding a quotient;
    rounding, by the device, the quotient to a nearest integer value, thereby yielding a rounded quotient; and
    determining, by the device, that a number of charged-particle events represented by the first cluster is equal to the rounded quotient.

7. The computer-implemented method of claim 6 further comprising, for a first pixel in the first cluster and having a first integrated charged-particle energy intensity:

    dividing, by the device, the first integrated charged-particle energy intensity by the first cumulative charged-particle energy intensity, thereby yielding a ratio;
    multiplying, by the device, the ratio by the rounded quotient, thereby yielding a product; and
    determining, by the device, that a number of charged-particle events represented by the first pixel is equal to the product.

8. The computer-implemented method of any preceding claim, wherein the step of accessing an energy integration image of a specimen scanned by a charged-particle microscope comprises accessing an energy integration image of a specimen scanned by an electron energy-loss microscope.

9. A computer program for facilitating charged-particle counting via non-backthinned integration detectors and beam energy quantization, the computer program product having program instructions executable by a processor to cause the processor to carry out the method steps of any of claims 1-8.

10. A computer program product upon which is embodied the computer program of claim 9.

11. A system comprising a memory within which is stored the computer program of claim 9 and a processor that executes the program instructions of the said computer program.

SCIENTIFIC INSTRUMENT MODULE
102

FIRST (IMAGE ACCESS)
LOGIC
104

SECOND (QUANTIZATION-
BASED COUNTING ) LOGIC
106

**FIG. 1**

200

PERFORM FIRST OPERATIONS ACCESSING, BY A DEVICE OPERATIVELY COUPLED TO A PROCESSOR, AN ENERGY INTEGRATION IMAGE OF A SPECIMEN SCANNED BY A CHARGED-PARTICLE MICROSCOPE THAT IS EQUIPPED WITH A NON-BACKTHINNED INTEGRATION DETECTOR

202

PERFORM SECOND OPERATIONS COUNTING, BY THE DEVICE, HOW MANY CHARGED-PARTICLE EVENTS ARE REPRESENTED BY RESPECTIVE PIXELS OF THE ENERGY INTEGRATION IMAGE, BASED ON ROUNDING CUMULATIVE CHARGED-PARTICLE ENERGY INTENSITIES INDICATED BY RESPECTIVE CLUSTERS OF PIXELS TO NEAREST INTEGER MULTIPLES OF A BEAM ENERGY OF THE CHARGED-PARTICLE MICROSCOPE

204

**FIG. 2**

EP 4 764 614 A1

SYSTEM 306

SOFTWARE COMPONENTS 311

QUANTIZATION COMPONENT 314

SCAN COMPONENT 312

PROCESSOR 308

MEMORY 310

CHARGED-PARTICLE MICROSCOPE 302

INTEGRATION DETECTOR 303

SPECIMEN 304

**FIG. 3**

SYSTEM 306

SOFTWARE COMPONENTS 311

SCAN COMPONENT 312

ENERGY INTEGRATION IMAGE 402

BEAM ENERGY 404

QUANTIZATION COMPONENT 314

PROCESSOR 308

MEMORY 310

CHARGED-PARTICLE MICROSCOPE 302

INTEGRATION DETECTOR 303

SPECIMEN 304

**FIG. 4**

CHARGED-PARTICLE MICROSCOPE 302

SPECIMEN 304

CAPTURE OR MEASURE VIA ANY SUITABLE ENERGY INTEGRATION IMAGING PROTOCOL;

THE BEAM ENERGY 404 CAN BE WHATEVER BEAM ENERGY IS USED IN SUCH PROTOCOL

502

PRELIMINARY ENERGY INTEGRATION IMAGE 502(1)

PIXEL 502(1)(1)

PIXEL 502(1)(P)

PRELIMINARY ENERGY INTEGRATION IMAGE 502(N)

PIXEL 502(N)(1)

PIXEL 502(N)(P)

EACH PIXEL CAN INDICATE THE SUMMED OR INTEGRATED AMOUNT OF ENERGY OF WHATEVER CHARGED-PARTICLES STRUCK A RESPECTIVE CELL OF THE INTEGRATION DETECTOR 303 DURING A RESPECTIVE SCAN

FIG. 5

```
┌─────────────────────────┐                              ┌ ─ ─ ─ ─ ─ ─ ─ ─ ─ ─ ─ ─ 604 ─ ─ ─ ─ ─ ─ ─ ─ ─ ─ ┐
│ PRELIMINARY ENERGY      │                              │  ┌──────────────────────────────────────────┐  │
│ INTEGRATION IMAGES      │                              │  │ FLOORED ENERGY INTEGRATION IMAGE  604(1)   │  │
│        502              │                              │  │  ┌──────────────────┐     ┌──────────────┐ │  │
└─────────────────────────┘                              │  │  │ PIXEL 604(1)(1)  │ ■ ■ ■ │ PIXEL 604(1)(P)│ │  │
                                                         │  │  └──────────────────┘     └──────────────┘ │  │
          PIXEL-WISE FLOORING TO ZERO                    │  └──────────────────────────────────────────┘  │
          BASED ON NOISE THRESHOLD 602      ──────────►  │                     ■                           │
                                                         │                     ■                           │
                                                         │                     ■                           │
┌─────────────────────────┐                              │  ┌──────────────────────────────────────────┐  │
│    NOISE THRESHOLD      │                              │  │ FLOORED ENERGY INTEGRATION IMAGE  604(N)   │  │
│        602              │                              │  │  ┌──────────────────┐     ┌──────────────┐ │  │
└─────────────────────────┘                              │  │  │ PIXEL 604(N)(1)  │ ■ ■ ■ │ PIXEL 604(N)(P)│ │  │
                                                         │  │  └──────────────────┘     └──────────────┘ │  │
                                                         │  └──────────────────────────────────────────┘  │
                                                         └ ─ ─ ─ ─ ─ ─ ─ ─ ─ ─ ─ ─ ─ ─ ─ ─ ─ ─ ─ ─ ─ ─ ─ ┘
```

**FIG. 6**

EP 4 764 614 A1

**FIG. 7**

FIG. 8

EP 4 764 614 A1

902

ENERGY INTEGRATION IMAGE 402

APPLICATION OF COMMUNITY DETECTION ALGORITHM

PIXEL CLUSTER 902(1)

NON-ZERO PIXEL 902(1)(1)

NON-ZERO PIXEL 902(1)($Q_1$)

PIXEL CLUSTER 902(M)

NON-ZERO PIXEL 902(M)(1)

NON-ZERO PIXEL 904(M)($Q_M$)

**FIG. 9**

PIXEL CLUSTER 902(*R*)

| NON-ZERO PIXEL 902(*R*)(1) | ■ ■ ■ | NON-ZERO PIXEL 904(*R*)($Q_R$) |

1002

INTEGRATED CHARGED-PARTICLE ENERGY INTENSITY 1002(1)

■ ■ ■

INTEGRATED CHARGED-PARTICLE ENERGY INTENSITY 1002($Q_R$)

SUMMATION

CUMULATIVE INTEGRATED CHARGED-PARTICLE ENERGY INTENSITY 1004

**FIG. 10**

CUMULATIVE
INTEGRATED
CHARGED-
PARTICLE
ENERGY
INTENSITY 1004

DIVISION →

QUOTIENT
1102

ROUNDING →

CUMULATIVE
CHARGED-PARTICLE
COUNT 1104

BEAM ENERGY 404

**FIG. 11**

1002

INTEGRATED CHARGED-PARTICLE ENERGY INTENSITY 1002(1)

■ ■ ■

INTEGRATED CHARGED-PARTICLE ENERGY INTENSITY 1002($Q_R$)

DIVISION AND MULTIPLICATION

CUMULATIVE INTEGRATED CHARGED-PARTICLE ENERGY INTENSITY 1004

CUMULATIVE CHARGED-PARTICLE COUNT 1104

PIXEL-WISE CHARGED-PARTICLE COUNT 1202(1)

■ ■ ■

PIXEL-WISE CHARGED-PARTICLE COUNT 1202($Q_R$)

1202

CAN BELONG TO THE PLURALITY OF PIXEL-WISE CHARGED PARTICLE COUNTS 802

**FIG. 12**

FIG. 13

EP 4 764 614 A1

FIG. 14

1500

1502

PROCESSING UNIT — 1504

1508  1506

SYSTEM MEMORY  1512

RAM

1510

ROM

1530
OPERATING SYSTEM

1532
APPLICATIONS

1534
MODULES

1536
DATA

1524
INTERFACE

1514
HDD

1526
INTERFACE

1516
EXTERNAL STORAGE

BUS

1528
INTERFACE

1520
DRIVE

1522
DISK

1546
MONITOR

1548
VIDEO ADAPTOR

1538
KEYBOARD

1540
TOUCH SCREEN

(WIRED/WIRELESS)

1544
INPUT DEVICE INTERFACE

1542
MOUSE

1560
MODEM

1556
WAN

1550
REMOTE COMPUTER(S)

1558
NETWORK ADAPTOR

(WIRED/WIRELESS)

1554
LAN

1552
MEMORY/ STORAGE

**FIG. 15**

FIG. 16

FIG. 17

EP 4 764 614 A1

44

**Europäisches Patentamt**
**European Patent Office**
**Office européen des brevets**

# EUROPEAN SEARCH REPORT

**Application Number**

EP 25 21 5228

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MOLDOVAN, G. ET AL: "Imaging modes for direct electron detection in TEM with column parallel CCD", NUCLEAR INSTRUMENTS & METHODS IN PHYSICS RESEARCH. SECTION A ELSEVIER BV * NORTH-HOLLAND, NL, vol. 607, no. 1, 1 August 2009 (2009-08-01), pages 13-16, XP026320931, ISSN: 0168-9002, DOI: 10.1016/J.NIMA.2009.03.105 [retrieved on 2009-03-24] * the whole document * | 1-11 | INV. G01T1/24 G01T1/29 H01J37/244 |
| A | Tate Mark W ET AL: "High Dynamic Range Pixel Array Detector for Scanning Transmission Electron Microscopy", Microscopy and microanalysis, 11 January 2016 (2016-01-11), pages 237-249, XP055839125, New York, USA DOI: 10.1017/S1431927615015664 Retrieved from the Internet: URL:https://pubmed.ncbi.nlm.nih.gov/267502 60/ [retrieved on 2021-09-08] * the whole document * | 1-11 | |
| A | US 2024/162002 A1 (RISSI MICHAEL [CH] ET AL) 16 May 2024 (2024-05-16) * paragraph [0008] - paragraph [0056]; figure 1 * | 1-11 | **TECHNICAL FIELDS SEARCHED (IPC)** G01T H01J |

The present search report has been drawn up for all claims

| Place of search | Date of completion of the search | Examiner |
|---|---|---|
| The Hague | 13 April 2026 | Gilow, Christoph |

## ANNEX TO THE EUROPEAN SEARCH REPORT
## ON EUROPEAN PATENT APPLICATION NO.

EP 25 21 5228

This annex lists the patent family members relating to the patent documents cited in the above-mentioned European search report.
The members are as contained in the European Patent Office EDP file on
The European Patent Office is in no way liable for these particulars which are merely given for the purpose of information.

13-04-2026

| Patent document cited in search report | Publication date | Patent family member(s) | Publication date |
|---|---|---|---|
| US 2024162002 A1 | 16-05-2024 | US 2024162002 A1 | 16-05-2024 |
| | | WO 2022184279 A1 | 09-09-2022 |

For more details about this annex : see Official Journal of the European Patent Office, No. 12/82

**EP 4 764 614 A1**

**Patent documents cited in the description**

- US 5851413 A, Casella
- US 5435850 A